# EUROPEAN PATENT APPLICATION

(11) **EP 4 780 157 A1**
(43) Date of publication of application: **22.07.2026**
(21) Application number: 25194498.9
(22) Date of filing: 07.08.2025
(51) Int. Cl.: H10B 12/00

(54) **SEMICONDUCTOR DEVICE**

(30) Priority: 20.01.2025 KR 20250007915
(71) Applicant: Samsung Electronics Co., Ltd., Suwon-si, Gyeonggi-do 16677 (KR)
(72) Inventor: HAN, Sang-il, 16677 Suwon-si, Gyeonggi-do (KR); KIM, Yoonjae, 16677 Suwon-si, Gyeonggi-do (KR); KIM, Jinah, 16677 Suwon-si, Gyeonggi-do (KR); HAN, Seunguk, 16677 Suwon-si, Gyeonggi-do (KR); HAN, Jinwoo, 16677 Suwon-si, Gyeonggi-do (KR); HONG, Seongbin, 16677 Suwon-si, Gyeonggi-do (KR)
(74) Representative: Kuhnen & Wacker Patent- und Rechtsanwaltsbüro PartG mbB

(57) **Abstract**

Provided is semiconductor device including a bit line (BL) extending in a first direction (D1), semiconductor patterns including a first material spaced apart from each other in the first direction (D1), and a first semiconductor pattern (200) including a first end and a second end in a second direction (D2), connected to the bit line (BL), a word line (WL) extending in a third direction (D3) and positioned on a first side of the first semiconductor pattern (200) in the first direction (D1), a data storage pattern (DS) including a first electrode (310) connected to the second end of the first semiconductor pattern (200), a second electrode (330) spaced apart from the first electrode (310), a dielectric layer (320) between the first and second electrodes (310, 330), and an etch stop layer (130) between the word line (WL) and the first electrode (310) and in contact with the first semiconductor pattern (200), and including a second material different from that of the first semiconductor pattern (200).

## Description

### BACKGROUND

Technology to improve integration of semiconductor devices may be desired. In the case of two-dimensional (2D) semiconductor devices, integration is mainly determined by the area occupied by a unit memory cell, and integration in this aspect may depend on levels of fine pattern formation technology.

### SUMMARY

The fine pattern formation technology can employ expensive equipment. Therefore, event though the integration of the 2D semiconductor devices is improved, the degree of integration achieved is still limited. Accordingly, 3D semiconductor memory devices having memory cells arranged in the 3D are discussed herein.

The present disclosure attempts to provide a semiconductor device that can increase the surface area of a data storage pattern by utilizing the separation distance along the vertical direction of semiconductor patterns, and can increase the contact area between the semiconductor patterns and the data storage pattern.

An implementation of the present disclosure provides a semiconductor device including a bit line extending in a first direction, a plurality of semiconductor patterns spaced apart from each other in the first direction, the plurality of semiconductor patterns comprising a (first) semiconductor pattern including a first end and a second end along a dimension of the (first) semiconductor pattern in a second direction that is different from the first direction, where the first direction is connected to the bit line, a word line structure extending in a third direction that is different from the first and second directions, wherein the word line structure is on a first side of the (first) semiconductor pattern, the first side facing in the first direction, where the (first) semiconductor pattern comprises a first material, a data storage pattern including a first electrode connected to the second end of the (first) semiconductor pattern, a second electrode spaced apart from the first electrode, and a dielectric layer between the first and second electrodes, and an etch stop layer between the word line structure and the first electrode of the data storage pattern, where the etch stop layer is in contact with the (first) semiconductor pattern, and includes a second material that is different from the first material, where a length of the first electrode of the data storage pattern in the first direction is greater than a length of the (first) semiconductor pattern in the first direction. For example, the word line structure comprises a first word line above the (first) semiconductor pattern in the first direction. For example, the word line structure comprises a second word line below the (first) semiconductor pattern in the first direction. For example, the semiconductor device comprises a gate insulating layer between the (first) semiconductor pattern and the word line structure. For example, the semiconductor device comprises a capping pattern on the first side of the (first) semiconductor pattern in the first direction. For example, the capping pattern is between the first word line and the etch stop layer in the second direction. For example, the capping pattern comprises a first capping portion between the word line structure and the etch stop layer in the second direction. For example, the capping pattern comprises a second capping portion between the word line separation layer and the etch stop layer in the second direction. For example, the semiconductor device comprises a spacer between the word line structure and the bit line in the second direction.

Another implementation of the present disclosure provides a semiconductor device including a bit line extending in a first direction, a plurality of semiconductor patterns spaced apart from each other in the first direction, the plurality of semiconductor patterns including a first semiconductor pattern which has a first end and a second end along a dimension of the first semiconductor pattern in a second direction that is different from the first direction, where the first end is connected to the bit line, a word line extending in a third direction that is different from the first direction and from the second direction, and where the word line is on a first side of the first semiconductor pattern, the first side facing in the first direction, where the first semiconductor pattern comprises a first material, a data storage pattern including a first electrode connected to the second end of the first semiconductor pattern, a second electrode spaced apart from the first electrode, and a dielectric layer between the first and second electrodes, and a semiconductor layer between the word line and the first electrode of the data storage pattern, where the semiconductor layer is in contact with the first semiconductor pattern, and where the semiconductor layer includes the first material.

Another implementation of the present disclosure provides a semiconductor device including a bit line extending in a first direction, a plurality of semiconductor patterns spaced apart from each other in the first direction, the plurality of semiconductor patterns including a first semiconductor pattern including a first end and a second end along a dimension of the first semiconductor pattern in a second direction that is different from the first direction, where the first end is connected to the bit line, a word line structure extending in a third direction that is different from the first direction and from the second direction, where the word line structure is on a first side of the first semiconductor pattern, the first side facing in the first direction, where the first semiconductor pattern includes a first material, and a data storage pattern including a first electrode connected to the second end of the first semiconductor pattern, a second electrode spaced apart from the first electrode, and a dielectric layer between the first and second electrodes, where a length of the first electrode of the data storage pattern in the first direction is greater than a length of the first semiconductor pattern in the first direction, and where the first electrode includes a first surface facing a first direction and a second surface facing in a direction opposite to that of the first direction, where the first surface and the second surface of the first electrode are non-overlapping with the word line structure.

Another implementation of the present disclosure provides a method for manufacturing a semiconductor device include providing a preliminary stack including a bit line extending in a first direction, preliminary semiconductor patterns connected at one end to the bit line in a second direction different from the first direction and spaced apart in the first direction, and a word line extending in a third direction different from the first and second directions and positioned on one side of the preliminary semiconductor pattern in the first direction, growing a semiconductor material layer on the other end of the preliminary semiconductor pattern in the second direction using a selective epitaxial growth (SEG) method, removing a portion of the preliminary semiconductor pattern and the semiconductor material layer, forming a first electrode in a space where the portion of the preliminary semiconductor pattern and semiconductor material layer have been removed, forming a dielectric layer on the first electrode, and forming a second electrode on the dielectric layer to form a data storage pattern.

Providing the preliminary stack may include forming the preliminary semiconductor patterns spaced apart in a first direction, forming the word line on one side of the preliminary semiconductor pattern in a second direction, and forming the bit line at one end of the preliminary semiconductor pattern in the second direction.

Forming preliminary semiconductor patterns may include alternately stacking sacrificial layers and active layers on a substrate, patterning the sacrificial layers and active layers to form a first trench extending in the second direction, forming a first preliminary filling pattern within the first trench, forming a second trench extending in the third direction at one end of the active layers in the second direction, removing the sacrificial layers exposed by the second trench at one side in the second direction, forming a second preliminary filling pattern within the second trench, forming a third trench extending in the third direction at the other end of the active layers in the second direction, removing the other sacrificial layers exposed by the third trench, and forming a third preliminary filling pattern within the third trench.

Providing the preliminary stack may include forming preliminary semiconductor patterns, removing the second preliminary filling pattern, forming a gate insulation layer and word lines between the preliminary semiconductor patterns spaced apart in the first direction, forming a word line separation layer between the word lines, forming a bit line at one end of the preliminary semiconductor patterns in the second direction, removing the third preliminary filling pattern, forming a capping pattern covering the other end of the word line in the second direction, and forming an etch stop layer at the other end of the capping pattern in the second direction.

One side of the preliminary semiconductor pattern in the second direction may penetrate the etch stop layer and is exposed, while the first preliminary filling patterns may be positioned on both sides of the preliminary semiconductor pattern in the third direction, and the semiconductor material layer may be grown in the space surrounded by the preliminary semiconductor pattern, the etch stop layer, and the first preliminary filling patterns through a selective epitaxial growth method using the preliminary semiconductor pattern as a seed.

A semiconductor material layer may be grown on the top surface in the first direction, the bottom surface in the first direction, and the other end in the second direction of the preliminary semiconductor pattern.

The semiconductor material layer may be in contact with heterogeneous interfaces having the semiconductor pattern, the etch stop layer, and the first preliminary filling pattern, which include different materials.

When removing a portion of the preliminary semiconductor pattern and the semiconductor material layer, part of the semiconductor material layer may remain on the second direction surface of the etch stop layer, resulting in the formation of a semiconductor layer positioned between the word line and the first electrode of the data storage pattern.

Forming a data storage pattern may include forming a fourth preliminary filling pattern between preliminary semiconductor patterns on which the semiconductor material layer is formed on a surface, removing a portion of the preliminary semiconductor and the semiconductor material layer on the surface, forming a first electrode in the space surrounded by the first preliminary filling pattern and the fourth preliminary filling pattern where the portion of the preliminary semiconductor pattern and semiconductor material layer have been removed, removing the first preliminary filling pattern and the fourth preliminary filling pattern, forming a dielectric layer over the first electrode, and forming a second electrode over the dielectric layer.

The first electrode may be formed in a thin film shape in the space surrounded by the first preliminary filling pattern and the fourth preliminary filling pattern, the dielectric layer is formed in a thin film shape on the internal and external surfaces of the first electrode, and the second electrode can be formed to fill the internal space and external space of the first electrode with the dielectric layer in between.

The semiconductor device, according to one or more implementations, can increase the surface area of a data storage pattern by utilizing the separation distance in the vertical direction of semiconductor patterns, and can increase the contact area between the semiconductor patterns and the data storage pattern.

### BRIEF DESCRIPTION OF THE DRAWINGS

FIG. 1 is a perspective view showing a portion of a semiconductor device according to an implementation.
FIG. 2 is a cross-sectional view taken along line A-A' of FIG. 1.
FIG. 3 is a cross-sectional view taken along line B-B' of FIG. 1.
Fig. 4 is a cross-sectional view taken along line A-A' of Fig. 1, showing another implementation.
FIG. 5 is a cross-sectional view taken along line B-B' of FIG. 1, showing another implementation.
FIG. 6 is a cross-sectional view seen along line A-A' of FIG. 1, showing another implementation.
FIG. 7 is a cross-sectional view taken along line A-A' of FIG. 1, showing another implementation.
FIGS. 8 to 30 are cross-sectional views showing a method for manufacturing a semiconductor device according to an implementation in process order.
FIGS. 31 to 38 are cross-sectional views showing a method for manufacturing a semiconductor device according to another implementation in process order.

### DETAILED DESCRIPTION

Hereinafter, various implementations of the present disclosure will be described in detail with reference to the attached drawings so that a person having ordinary skill in the art to which the present disclosure pertains can easily implement the present disclosure. The present disclosure may be embodied in many different forms and is not limited to the implementations set forth herein.

The drawings and description are to be regarded as illustrative in nature and not restrictive. Like reference numerals designate like elements throughout the specification.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means being disposed on or below the object portion, and does not necessarily mean being disposed on the upper side of the object portion based on a gravitational direction.

Additionally, throughout the specification, the direction vertical to the upper surface of the substrate is described as a first direction D1, and the two directions that are parallel to the upper surface of the substrate and intersect each other are described as a second direction D2 and a third direction D3 respectively. For example, the second direction D2 and the third direction D3 may be perpendicular to each other. As an example, the second direction D2 and the third direction D3 may each be perpendicular to the first direction D1.

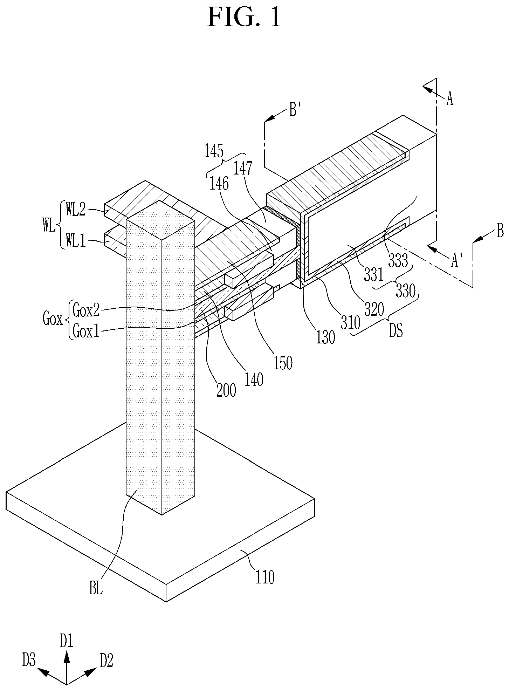

Hereinafter, referring to FIGS. 1 to 3, a semiconductor device according to an implementation will be described.

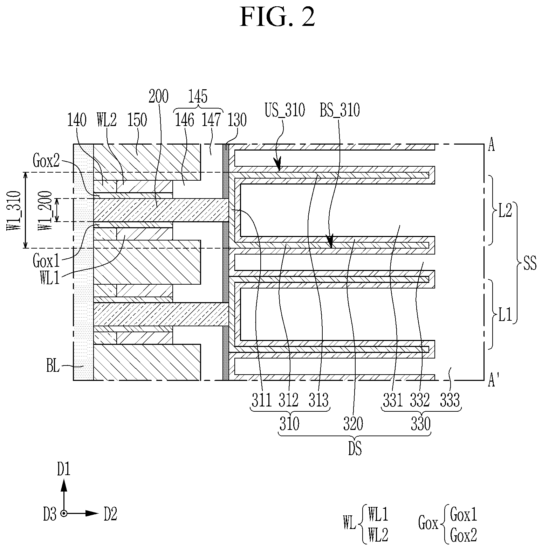

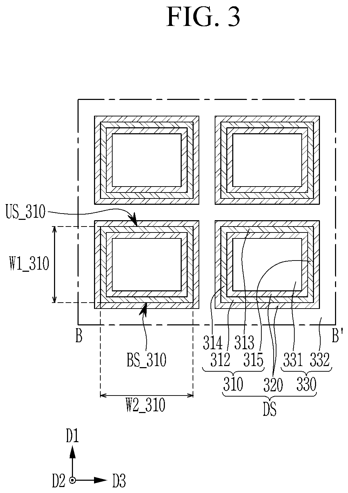

FIG. 1 is a perspective view showing a portion of a semiconductor device according to an implementation. FIG. 2 is a cross-sectional view taken along line A-A' of FIG. 1. FIG. 3 is a cross-sectional view taken along line B-B' of FIG. 1.

Referring to FIGS. 1 to 3, the semiconductor device may include memory cells arranged in 3-dimensions. The memory cells may be arranged in a first direction D1, second direction D2, and third direction D3. For example, the memory cells may be stacked in the first direction D1.

Each memory cell may be connected to a bit line BL and a word line WL. The bit line BL may extend along the first direction D1. The memory cells stacked in the first direction D1 may be commonly connected to a single bit line BL. A plurality of bit lines BL may be arranged spaced apart along the third direction D3. The word line WL may extend along the third direction D3. The memory cells arranged in the first direction D1 may be commonly connected to a single word line WL. A plurality of the word lines WL may be spaced apart and arranged along the first direction D1.

FIG. 1 illustrates one memory cell and the bit line BL and the word line WL connected to it. For clarity and simplicity of illustration, other memory cells are omitted in FIG. 1. FIG. 1 shows only one cell of a stacking structure SS, which will be described later in FIG. 2.

FIG. 2 illustrates two memory cells stacked in a first direction D1 and commonly connected to a single bit line BL. FIG. 2 shows memory cells arranged spaced apart in the first direction D1, which were omitted in FIG. 1. For example, the stacking structure SS may include a first layer L1 and a second layer L2 sequentially stacked on the substrate 110. The first layer L1 and the second layer L2 may be stacked in a first direction D1 vertical to the substrate 110. The first layer L1 and the second layer L2 each may include a semiconductor pattern 200, a word line WL positioned on one side of the semiconductor pattern 200 in the first direction D1, and a data storage pattern DS connected to the semiconductor pattern 200. In FIG. 2, the stacking structure SS is shown to include two layers, but is not limited to this. In some implementations, the stacking structure SS may include more layers.

Additionally, in FIG. 2, each layer of the stacking structure SS is shown to include one memory cell, but this is not limited to this. In some implementations, each layer of the stacking structure SS may include more cells. For example, each layer of the stacking structure SS may further include memory cells that are mirror-symmetrical in the second direction D2 with the structure of the memory cell shown in FIG. 2. For example, a stacking structure that is mirror-symmetrical to the stacking structure SS of FIG. 2 may be further positioned on substrate 110 in the second direction D2. The stacking structure SS and a stacking structure that is mirror-symmetrical to the stacking structure SS may form a pair. A pair of stacking structures may share the second electrode 330 of the data storage patterns DS to be described later.

For example, the stacking structure SS may be positioned on the substrate 110. The substrate 110 may include, for example, silicon, germanium, or silicon-germanium. The stacking structure SS may constitute the memory cell array of a semiconductor device.

In some implementations, a peripheral circuit for operating a memory cell array may be positioned on the substrate 110. Additionally, wirings that are electrically connected to the bit lines BL and the word lines WL may be positioned on top of the stacking structure SS, and these wirings may be connected to the peripheral circuit.

The bit line BL may be positioned on one side of the second direction D2 of the stacking structure SS. The bit line BL may extend in the first direction D1. For example, the bit line BL may have a line shape or pillar shape extending in the first direction D1.

The bit line BL may be contact with one side of the semiconductor pattern 200 in the second direction D2. The bit line BL may be electrically connected to the semiconductor pattern 200.

The bit line BL may include conductive material. The conductive materials may include doped semiconductor materials such as doped silicon or doped germanium, conductive metal nitrides such as titanium nitride or tantalum nitride, metals such as tungsten, titanium, or tantalum, or metal-semiconductor compounds such as tungsten silicide, cobalt silicide, or titanium silicide, or combinations thereof.

In some implementations, a first interlayer insulating layer may be positioned on one side of the stacking structure SS in the second direction D2. The first interlayer insulating layer may extend in a first direction D1 vertical to the substrate 110. Additionally, the first interlayer insulating layer may extend along the third direction D3. The bit line BL may be positioned on one side of the first interlayer insulating layer in the second direction D2. Additionally, the first interlayer insulating layer may also be positioned between the bit lines BL that are arranged spaced apart along the third direction D3. The bit lines BL, which are arranged spaced apart along the third direction D3, may be insulated from each other by the first interlayer insulating layer.

The first interlayer insulating layer may include, for example, a silicon nitride layer, a silicon oxide nitride layer, a carbon-containing silicon oxide layer, a carbon-containing silicon nitride layer, a carbon-containing silicon oxide nitride layer, or a combination thereof.

The word line WL may extend along the third direction D3. The word line WL may have a line shape that extends in the third direction D3. The word line WL may have a first word line WL1 passing above the semiconductor pattern 200 in the first direction D1 and a second word line WL2 passing below the semiconductor pattern 200 in the first direction D1. In other words, the first word line WL1 and the second word line WL2 may be positioned apart from each other in the first direction D1 with the semiconductor pattern 200 in between. In some implementations, the word line WL extends along the third direction D3, and in regions where it does not pass through the semiconductor pattern 200, the first word line WL1 and the second word line WL2 may merge. The word line WL may surround the semiconductor pattern 200.

The word line WL may include conductive material. For example, the conductive material may include semiconductor material, conductive metal nitride, metal, metal-semiconductor compound, or a combination thereof.

A spacer 140 may be positioned between the word line WL and the bit line BL. The spacer 140 may include insulating material, may separate the bit line BL and word line WL in the second direction D2, and may insulate them from each other.

For example, the spacer 140 may include silicon nitride layer, silicon oxide nitride layer, carbon-containing silicon oxide layer, carbon-containing silicon nitride layer, carbon-containing silicon oxide nitride layer, or a combination thereof.

A gate insulation layer Gox may be positioned between the word line WL and the semiconductor pattern 200. The gate insulation layer Gox may also be positioned between the spacer 140 and the semiconductor pattern 200. In some implementations, the gate insulation layer Gox may surround the word line WL and spacer 140. The gate insulation layer Gox may cover an upper surface, sides, and a bottom surface of the word line WL. The gate insulation layer Gox may cover an upper surface and a bottom surface of spacer 140.

The gate insulation layer Gox may contact the bit line BL. The bottom surface of spacer 140 and the portion of the gate insulation layer Gox covering the bottom surface of the word line WL may be in contact with the bit line BL. In some implementations, portions of the gate insulation layer Gox covering the upper surface of the spacer 140 and the upper surface of the word line WL may also contact the bit line BL.

The gate insulation layer Gox may have a first gate insulation layer Gox1 positioned between the first word line WL1 and the semiconductor pattern 200, and a second gate insulation layer Gox2 positioned between the second word line WL2 and the semiconductor pattern 200. The semiconductor pattern 200 may be spaced apart from the first word line WL1 by the first gate insulation layer Gox1. The semiconductor pattern 200 may be spaced apart from the second word line WL2 by the second gate insulation layer Gox2. In some implementations, the first gate insulation layer Gox1 and the second gate insulation layer Gox2 may meet each other on both sides of the semiconductor pattern 200 in the second direction D2. Accordingly, the gate insulation layer Gox may surround the semiconductor pattern 200.

The gate insulation layer Gox may include a high-dielectric layer, silicon oxide layer, silicon nitride layer, silicon oxide nitride layer, or a combination thereof. The high dielectric layer may include, for example, hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, lead zinc niobate, or combinations thereof.

The stacking structure SS may include a plurality of layers, and the word line separation layers 150 may be positioned between two adjacent layers of the stacking structure SS. Word line separation layer 150 may be positioned between the first layer L1 and the second layer L2. The word line WL and the semiconductor pattern 200 of each layer may be located on the word line separation layer 150. The word lines WL of the upper layer and the word lines WL of the lower layer may be spaced apart in the first direction D1 by the word line separation layer 150 in the first direction D1. In the first direction D1, the semiconductor pattern 200 of the upper layer and the semiconductor pattern 200 of the lower layer may be spaced apart in the first direction D1 by the word line separation layer 150. The word line separation layer 150 may extend in the third direction D3 along the word line WL.

One end of the word line separation layer 150 in the second direction D2 may be connected to the bit line BL. The other end of the word line separation layer 150 in the second direction D2 may be connected to the capping pattern 145.

The word line separation layer 150 may include insulating material, for example, silicon nitride layer, silicon oxide nitride layer, carbon-containing silicon oxide layer, carbon-containing silicon nitride layer, or carbon-containing silicon oxide nitride layer.

In some implementations, the word line separation layer 150 may include a separation liner and a separation filling layer positioned between the separation liner. The separation liner may conformally cover the upper surface and bottom surface of the word line WL in the first direction D1, and the separation filling layer may fill the space between the separation liners. The separation liner and the separation filling layer may each include insulating material.

The semiconductor pattern 200 may be positioned in each layer of the stacking structure SS.

One end of the semiconductor pattern 200 in the second direction D2 may be connected to the bit line BL. The other end of the semiconductor pattern 200 in the second direction D2 may be connected to the data storage pattern DS.

A plurality of the semiconductor patterns 200 may be arranged spaced apart in a first direction D1 along the elongation direction of the bit line BL. Additionally, a plurality of the semiconductor patterns 200 may be arranged spaced apart along the third direction D3 following the spacing direction of the bit line BL. For example, the semiconductor pattern 200 may have a length in the third direction D3 that is greater than the length of the semiconductor pattern 200 in the first direction D1, and the semiconductor pattern 200 may have a spacing distance in the first direction D1 that is greater than the spacing distance of the semiconductor pattern 200 in the third direction D3.

The semiconductor pattern 200 may be positioned between the first gate insulation layer Gox1 and the second gate insulation layer Gox2. The semiconductor pattern 200 may be surrounded by the gate insulation layer Gox. The semiconductor pattern 200 may be surrounded by the word line WL with the gate insulation layer Gox in between. The semiconductor pattern 200 may be positioned between the first word line WL1 and the second word line WL2.

At least part of the semiconductor pattern 200 may overlap with the word line WL in the first direction D1. At least part of the semiconductor pattern 200 may overlap with the spacer 140 and the capping pattern 145 in the first direction D1.

Additionally, one end of the semiconductor pattern 200 in the second direction D2 may overlap with the etch stop layer 130 in the first direction D1. The other end of the semiconductor pattern 200 in the second direction D2 may directly contact the etch stop layer 130. The upper or lower surface of the semiconductor pattern 200 in the first direction D1 may contact the etch stop layer 130 at the other end in the second direction D2. The other end of the semiconductor pattern 200 in the second direction D2 and the etch stop layer 130 may form a coplanar surface. Accordingly, the other side of the semiconductor pattern 200 in the second direction D2 may contact the first electrode 310 of the data storage pattern DS by penetrating through the etch stop layer 130. The first electrode 310 of the data storage pattern DS may simultaneously contact one side of the second direction D2, the other end of the second direction D2 of the semiconductor pattern 200, and the etch stop layer 130.

The semiconductor pattern 200 may include one or more semiconductor materials. For example, the semiconductor pattern 200 may include monocrystalline silicon. In some implementations, the semiconductor pattern 200 may include an oxide semiconductor material. The oxide semiconductor material may be a combination of at least 2 or more of In, Ga, Zn, Al, Sn, and Hf, but is not limited thereto. The oxide semiconductor material may additionally include materials such as Si, Mg, Ta, La, Nd, Ce, Sc, Cr, Co, Nb, Mo, Ba, Gd, Ti, W, Pd, Ru, Ni, or Mn in the composition. For example, the semiconductor pattern 200 may include IGZO (indium gallium zinc oxide), ITZO (indium tin zinc oxide), IZO (indium zinc oxide), ZnO (zinc oxide), ZTO (zinc tin oxide), ZnON (zinc oxynitride), ZZTO (zirconium zinc tin oxide), SnO (tin oxide), HIZO (hafnium indium zinc oxide), GZTO (gallium zinc tin oxide), AZTO (aluminium zinc tin oxide), YGZO (ytterbium gallium zinc oxide), IGO (indium gallium oxide) or a combination thereof.

The semiconductor pattern 200 may have impurity regions and a channel region between the impurity regions. The impurity regions may correspond to the source/drain region of the memory cell transistor. The impurity regions may be regions in the semiconductor pattern 200 where impurities have been doped. The impurity regions may have either n-type or p-type conductivity. The impurity regions may be positioned adjacent to both ends of the semiconductor pattern 200 in the second direction D2.

The capping pattern 145 may be positioned on one side or both sides of the semiconductor pattern 200 in the first direction D1. The one or both sides of the first direction D1 of the capping pattern 145 may contact with the semiconductor pattern 200. The capping pattern 145 may be alternatively arranged with the semiconductor pattern 200 in the first direction D1.

The capping pattern 145 may extend in the third direction D3 along the word line WL. The capping pattern 145 may extend in the third direction D3 along the word line separation layer 150.

For example, the capping pattern 145 may have a first capping portion 146 and a second capping portion 147. The first capping portion 146 may be positioned on both sides of the second capping portion 147 in the first direction D1.

The capping portion 146 may be positioned between the word line WL and the data storage pattern DS in the second direction D2. The capping portion 146 may be positioned between the word line WL and the etch stop layer 130 in the second direction D2. The first capping portion 146 may be positioned between the first word line WL1 and the etch stop layer 130 in the second direction D2, and the first capping portion 146 may be positioned between the second word line WL2 and the etch stop layer 130 in the second direction D2. In other words, one side of the second direction D2 of the first capping portion 146 may contact with the first word line WL1 and the second word line WL2. Additionally, one side of the first capping portion 146 in the second direction D2 may also contact the gate insulation layer Gox. The first capping portion 146 may contact the etch stop layer 130 on the other side of the second direction D2.

The second capping portion 147 may be positioned between the word line separation layer 150 and the data storage pattern DS in the second direction D2. The second capping portion 147 may be positioned between the word line separation layer 150 and the etch stop layer 130 in the second direction D2. In other words, one side of the second direction D2 of the second capping portion 147 may be in contact with the word line separation layer 150. The second capping portion 147 in the second direction D2 may contact the etch stop layer 130.

The capping pattern 145 may include insulating material. The capping pattern 145 may include, for example, a silicon oxide layer, a silicon nitride layer, a silicon nitride layer, or a combination thereof.

The etch stop layer 130 may be positioned between the word line WL and the first electrode 310 of the data storage pattern DS. The etch stop layer 130 may be positioned between the capping pattern 145 and the first electrode 310 of the data storage pattern DS. One side of the etch stop layer 130 in the second direction D2 may contact the capping pattern 145. The etch stop layer 130 may conformally cover the other side of the capping pattern 145 in the second direction D2. In other words, the etch stop layer 130 may be a thin film having a uniform thickness along the surface shape of the other side in the second direction D2 of the capping pattern 145.

The other side of the etch stop layer 130 in the second direction D2 may contact the data storage pattern DS. The other side of the etch stop layer 130 in the second direction D2 may contact the first electrode 310 of the data storage pattern DS. The other side of the etch stop layer 130 in second direction D2 that does not contact the first electrode 310 of the data storage pattern DS may contact the dielectric layer 320 of the data storage pattern DS. The etch stop layer 130 may not contact the second electrode 330 of the data storage pattern DS.

The etch stop layer 130 may have a portion positioned above the semiconductor pattern 200 in the first direction D1 and a portion positioned below the semiconductor pattern 200 in the first direction D1. In other words, the etch stop layer 130 may be arranged spaced apart in the first direction D1 with the semiconductor pattern 200 interposed between.

In addition, the etch stop layer 130 may overlap with the other end in the second direction D2 of the semiconductor pattern 200 in the first direction D1. The etch stop layer 130 may directly contact the other end of the semiconductor pattern 200 in the second direction D2. The etch stop layer 130 may contact the other end in the second direction D2 of the upper surface and the lower surface of the semiconductor pattern 200 in the first direction D1. The etch stop layer 130 and the other end in the second direction D2 of the semiconductor pattern 200 may form a coplanar surface. As a result, the other end in the second direction D2 of the semiconductor pattern 200 may contact with the first electrode 310 of the data storage pattern DS by penetrating through the etch stop layer 130. In other words, one side of the first electrode 310 of the data storage pattern DS in the second direction D2 may simultaneously contact the other end in the second direction D2 of the semiconductor pattern 200 and the etch stop layer 130.

The etch stop layer 130 may include a different material than the semiconductor pattern 200. For example, the etch stop layer 130 may include a material that has etch selectivity with respect to the material of the semiconductor pattern 200. Therefore, the etch stop layer 130 may not include the semiconductor material that the semiconductor pattern 200 may include, for example, monocrystalline silicon or oxide semiconductor material. For example, the etch stop layer 130 may include silicon nitride, silicon oxidation nitride, carbon-containing silicon oxide, carbon-containing silicon nitride, carbon-containing silicon oxidation nitride, or a combination thereof.

Accordingly, one side of the first electrode 310 in the second direction D2 of the data storage pattern DS may be in contact with a heterogeneous interface having the semiconductor pattern 200 and the etch stop layer 130, which include different materials.

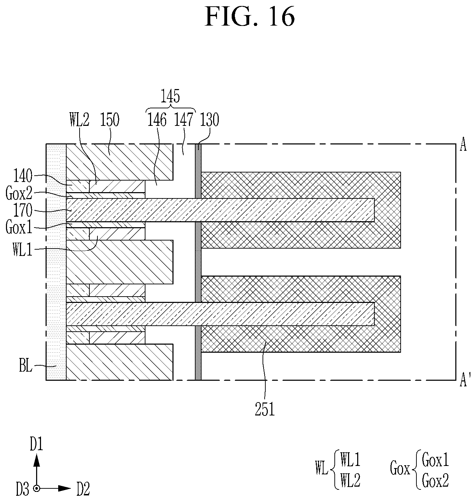

Additionally, the etch stop layer 130 may include a material different from the material of the first preliminary filling pattern PF1 in FIG. 16 to be described later. For example, when the first preliminary filling pattern PF1 includes silicon nitride, the etch stop layer 130 may include silicon oxide. However, it is not limited thereto, and the material of the etch stop layer 130 and the material of the first preliminary filling pattern PF1 may include various materials as long as they have etch selectivity with respect to each other.

Accordingly, as described later in FIG. 16, in a space surrounded by the preliminary semiconductor pattern 170 in FIG. 16, the etch stop layer 130, and the first preliminary filling pattern PF1, a semiconductor material layer 251 in FIG. 16 may be grown only on the surface of the preliminary semiconductor pattern 170 by a selective epitaxial growth method.

The data storage pattern DS may be electrically connected to semiconductor pattern 200. The data storage pattern DS is a memory element that may store data, for example, it may be a memory element using a capacitor, a memory element using a magnetic tunnel junction pattern, or a memory element using a variable resistor body containing phase change material.

For example, the data storage pattern DS may be a capacitor. The data storage pattern DS may include a first electrode 310, a second electrode 330 spaced apart from the first electrode 310, and a dielectric layer 320 positioned between the first electrode 310 and the second electrode 330.

The first electrode 310 may have a first side wall 311, a second side wall 312, a third side wall 313, a fourth side wall 314, and a fifth side wall 315.

The first side wall 311 may be positioned on one side of the data storage pattern DS the second direction D2 . For example, the first side wall 311 may have a horizontal surface with the first direction D1 and the third direction D3. The first side wall 311 may be in contact with a coplanar surface of the semiconductor pattern 200 and the etch stop layer 130. The first side wall 311 may primarily overlap with the second electrode 330 in the second direction D2. The first side wall 311 may contact one side in the second direction D2 of each of the second side wall 312, the third side wall 313, the fourth side wall 314, and the fifth side wall 315.

The second side wall 312 and the third side wall 313 may be arranged spaced apart from each other in the first direction D1. The second side wall 312 and the third side wall 313 may each contact one side and the other side of the first side wall 311 in the first direction D1. The second side wall 312 and the third side wall 313 may each extend from the first side wall 311 in the second direction D2. For example, the second side wall 312 and the third side wall 313 may have surfaces that are horizontal with the second direction D2 and the third direction D3. The second side wall 312 and the third side wall 313 may each be alternately arranged with the second electrode 330 in the first direction D1. In other words, the second side wall 312 and the third side wall 313 may primarily overlap with the second electrode 330 in the first direction D1.

The fourth side wall 314 and the fifth side wall 315 may be arranged separated from each other in the third direction D3. The fourth side wall 314 and the fifth side wall 315 may each contact one side and the other side of the first side wall 311 in the third direction D3. The fourth side wall 314 and the fifth side wall 315 may each contact one side and the other side in the third direction D3 of the second side wall 312 and the third side wall 313, respectively. The fourth side wall 314 and the fifth side wall 315 may each extend in the second direction D2 from the first side wall 311. Additionally, the fourth side wall 314 and the fifth side wall 315 may each extend in the first direction D1 between the second side wall 312 and the third side wall 313. For example, the fourth side wall 314 and the fifth side wall 315 may have surfaces that are horizontal to the first direction D1 and the second direction D2. The fourth side wall 314 and the fifth side wall 315 may each be alternately arranged with the second electrode 330 in the third direction D3. In other words, the fourth side wall 314 and the fifth side wall 315 may primarily overlap with the second electrode 330 in the third direction D3.

For example, the first electrode 310 may have an internal space surrounded by the first side wall 311, the second side wall 312, the third side wall 313, the fourth side wall 314, and the fifth side wall 315. In other words, the first electrode 310 may have a cylinder shape that extends in the second direction D2. The inner space of the first electrode 310 may also position the second electrode 330, thereby further increasing the surface area of the data storage pattern DS.

The second electrode 330 may have an inner portion 331, an outer portion 332, and a connection portion 333.

The inner portion 331 may be positioned inside the first electrode 310. The inner portion 331 may be inserted into the first electrode 310 and may be surrounded by the first electrode 310. For example, the inner portion 331 may be positioned in an internal space surrounded by the first side wall 311, the second side wall 312, the third side wall 313, the fourth side wall 314, and the fifth side wall 315 of the first electrode 310, and may be inserted into the internal space of the first electrode 310, which may have a cylindrical shape. The inner portion 331 may extend in the second direction D2 along the second side wall 312, the third side wall 313, the fourth side wall 314, and the fifth side wall 315 of the first electrode 310.

The outer portion 332 may be positioned outside the first electrode 310. The outer portion 332 may surround the first electrode 310. For example, the outer portion 332 may be positioned outside an internal space surrounded by the first side wall 311, the second side wall 312, the third side wall 313, the fourth side wall 314, and the fifth side wall 315 of the first electrode 310, and may be positioned in the external space of the first electrode 310, which is, for example, in a cylindrical shape. The outer portion 332 may extend in the second direction D2 along the second side wall 312, the third side wall 313, the fourth side wall 314, and the fifth side wall 315 of the first electrode 310.

The connection portion 333 may be positioned on the other side of the first electrode 310 in the second direction D2. The connection portion 333 may connect the outer portion 332 and the inner portion 331. The connection portion 333 may be in contact with the other side of the outer portion 332 in the second direction D2, and the connection portion 333 may be positioned on the other side of the inner portion 331 in the second direction D2. The connection portion 333 may extend in the first direction D1 along the stacking structure SS to connect the plurality of the outer portions 332 and the inner portions 331. Hereby, the data storage patterns DS of a plurality of layers stacked in a first direction D1 may share a single second electrode 330.

The first electrode 310 and the second electrode 330 may each include a metallic material such as titanium, tantalum, tungsten, copper, or aluminum, a conductive metal nitride such as titanium nitride or tantalum nitride, or a doped semiconductor material such as doped silicon or doped germanium.

The dielectric layer 320 may be positioned between the first electrode 310 and the second electrode 330. The dielectric layer 320 may conformally cover the top of the first electrode 310. In other words, the dielectric layer 320 may be a thin film having a uniform thickness along the second direction D2 different side surface shape of the first electrode 310.

The dielectric layer 320 may cover the internal surface and the external surface of the first electrode 310. In other words, the dielectric layer 320 may cover the other side of the first side wall 311 of the first electrode 310 in the second direction D2. The dielectric layer 320 may cover one side and the other side in the first direction D1 of the second side wall 312 and the third side wall 313 of the first electrode 310. The dielectric layer 320 may cover one side and the other side of the fourth side wall 314 and the fifth side wall 315 of the first electrode 310 in the third direction D3.

The dielectric layer 320 positioned inside the first electrode 310 may be surrounded by the first electrode 310. The dielectric layer 320, positioned outside the first electrode 310, may surround the first electrode 310. The dielectric layer 320 positioned outside the first electrode 310 may be surrounded by the second electrode 330.

For example, the dielectric layer 320 may include dielectric material, ferromagnetic body, semi-ferromagnetic body, or a combination thereof. The dielectric material may include high dielectric constant material. For example, the dielectric material may include hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, lead zinc niobate, or a combination thereof.

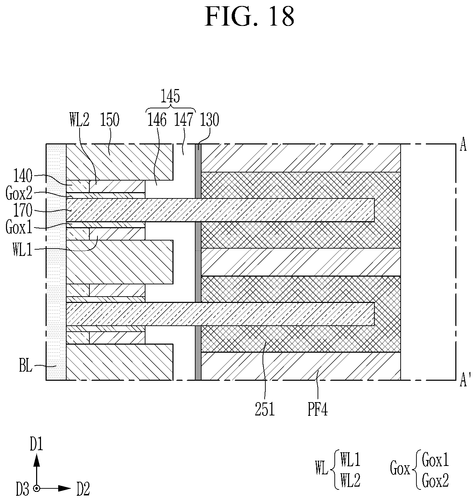

As described later in FIGS. 18 to 24, the first electrode 310 of the data storage pattern DS may be formed in a space where a part of the preliminary semiconductor pattern 170 in FIG. 18 is removed, thereby self-aligning the semiconductor pattern 200 and the first electrode 310 of the data storage pattern DS. However, there is a limitation in increasing the surface area of the data storage pattern DS due to the length W1_310 of the first electrode 310 of the data storage pattern DS along the first direction D1 being restricted by the length W1_200 of the semiconductor pattern 200 along the first direction D1. On the other hand, the semiconductor pattern 200 has a length along the third direction D3 greater than a length along the first direction D1, and the semiconductor pattern 200 has a separation distance along the first direction D1 greater than the separation distance along the third direction D3. In other words, the semiconductor device needs to increase the surface area of the data storage pattern DS by utilizing the separation distance along the first direction D1 of the semiconductor pattern 200.

As described above, the semiconductor device includes an etch stop layer 130 that directly contacts the semiconductor pattern 200, so that the other side of the semiconductor pattern 200 in the second direction D2 may be connected to the first electrode 310 of the data storage pattern DS through the etch stop layer 130. In other words, one side of the first electrode 310 in the second direction D2 of the data storage pattern DS may be in contact with a heterogeneous interface having the semiconductor pattern 200 and the etch stop layer 130, which include different materials.

As described later in FIG. 16, a semiconductor material layer 251 may be grown only on the surface of the preliminary semiconductor pattern 170 by a selective epitaxial growth method in the space surrounded by the preliminary semiconductor pattern 170, etch stop layer 130, and first preliminary filling pattern PF1. Accordingly, by increasing the length of the preliminary semiconductor pattern 170 along the first direction D1, and then forming the first electrode 310 of the data storage pattern DS in the space where the preliminary semiconductor pattern 170 with increased length along the first direction D1 has been removed, the surface area of the data storage pattern DS may be increased. In other words, as the semiconductor device includes the etch stop layer 130, the preliminary semiconductor pattern 170 and the etch stop layer 130 form a heterogeneous interface, making it possible to grow the semiconductor material layer 251 only on the surface of the preliminary semiconductor pattern 170 through a selective epitaxial growth method.

Accordingly, the length W1_310of the first electrode 310 of the data storage pattern DS in the first direction D1 may be greater than the length W1_200 of the semiconductor pattern 200 in the first direction D1. The semiconductor device may increase the surface area of the data storage pattern DS by utilizing the spacing distance along the first direction D1 of the semiconductor pattern 200.

Here, the length W1_310 of the first electrode 310 of the data storage pattern DS in the first direction D1 may be the shortest distance in the first direction D1 from the bottom surface of the second side wall 312 of the first electrode 310 in the first direction D1 to the upper surface of the third side wall 313 of the first electrode 310 in the first direction D1. Or, the length W1_310 of the first electrode 310 of the data storage pattern DS in the first direction D1 may be the shortest distance in the first direction D1 from the bottom of the first side wall 311 of the first electrode 310 in the first direction D1 to the top of the first side wall 311 in the first direction D1. Additionally, the length W1_200 of the semiconductor pattern 200 in the first direction D1 may be the shortest distance in the first direction D1 from the bottom surface of the semiconductor pattern 200 in the first direction D1 to the upper surface of the semiconductor pattern 200 in the first direction D1.

For example, the length W1_310 of the first electrode 310 of the data storage pattern DS in the first direction D1 may be more than 1.1 times the length of the semiconductor pattern 200 in the first direction D1, for example 1.2 times or more, 1.5 times or more, 2.0 times or more, 2.5 times or more, 3.0 times or more, 3.5 times or more, 4.0 times or more, or 4.5 times or more, and may be 5 times or less, for example, 4.5 times or less, 4.0 times or less, 3.5 times or less, 3.0 times or less, 2.5 times or less, 2.0 times or less, 1.5 times or less, or 1.2 times or less, for example, it may be more than 1.1 times and less than or equal to 5 times. In other words, the increased length W1_310 of the first electrode 310 of the data storage pattern DS in the first direction D1 is not at the level of a thin film, but may be several times greater than the length W1_200 of the semiconductor pattern 200 in the first direction D1.

The length W1_310 of the first electrode 310 of the data storage pattern DS in the first direction D1 may be 0.5 times or more than the length W3_310 of the first electrode 310 of the data storage pattern DS in the third direction D3, for example, 1.0 times or more, 1.5 times or more, 2.0 times or more, 2.5 times or more, 3.0 times or more, 3.5 times or more, 4.0 times or more, or 4.5 times or more, and may be 5.0 times or less, for example, 4.5 times or less, 4.0 times or less, 3.5 times or less, 3.0 times or less, 2.5 times or less, 2.0 times or less, 1.5 times or less, or 1.0 times or less, for example, 0.5 times to 5.0 times. In other words, the aspect ratio of the length W1_310 of the first electrode 310 in the first direction D1 to the length W3_310 of the first electrode 310 in the third direction D3 may be 0.5 to 5.0. The semiconductor device may increase the surface area of the data storage pattern DS by utilizing the separation distance according to the first direction D1 of the semiconductor pattern 200.

Here, the length W3_310 of the first electrode 310 of the data storage pattern DS in the third direction D3 may be the shortest distance in the third direction D3 from one side of the fourth side wall 314 of the first electrode 310 in the third direction D3 to the other side of the fifth side wall 315 of the first electrode 310 in the third direction D3. Or, the length W3_310 of the first electrode 310 of the data storage pattern DS in the third direction D3 may be the shortest distance in the third direction D3 from one side of the first side wall 311 in the third direction D3 to the other side of the first side wall 311 in the third direction D3.

As described above, as the semiconductor device includes the etch stop layer 130, the preliminary semiconductor pattern 170 and the etch stop layer 130 form a heterogeneous interface, and by growing the semiconductor material layer 251 only on the surface of the preliminary semiconductor pattern 170 through a selective epitaxial growth method to increase the length of the preliminary semiconductor pattern 170 in the first direction D1, both opposing faces of the first electrode 310 of the data storage pattern DS in the first direction D1 may not overlap with the word line WL in the second direction D2. For example, the bottom surface of the second side wall 312 of the first electrode 310 in the first direction D1 may not overlap with the first word line WL1 of the word line WL in the second direction D2. Additionally, the upper surface of the third side wall 313 of the first electrode 310 in the first direction D1 may not overlap with the second word line WL2 of the word line WL in the second direction D2.

For example, both sides of the first electrode 310 facing the first direction D1 of the data storage pattern DS may overlap with the word line separation layer 150 in the second direction D2. For example, the bottom surface of the second side wall 312 of the first electrode 310 in the first direction D1 may overlap with the word line separation layer 150 in the second direction D2. Additionally, the upper surface of the third side wall 313 of the first electrode 310 in the first direction D1 may overlap with the word line separation layer 150 in the second direction D2.

Additionally, both sides of the first electrode 310 in the first direction D1 of the data storage pattern DS may not overlap with the semiconductor pattern 200 in the second direction D2. For example, the bottom surface of the second side wall 312 of the first electrode 310 in the first direction D1 may not overlap with the semiconductor pattern 200 in the second direction D2. Additionally, the upper surface of the third side wall 313 of the first electrode 310 in the first direction D1 may not overlap with the semiconductor pattern 200 in the second direction D2.

As described above, in the space surrounded by the preliminary semiconductor pattern 170, etch stop layer 130, and first preliminary filling pattern PF1, by growing the semiconductor material layer 251 only on the surface of the preliminary semiconductor pattern 170 through selective epitaxial growth method, the semiconductor material layer 251 may be grown only on the upper surface and lower surface of the preliminary semiconductor pattern 170 in the first direction D1, and the semiconductor material layer 251 may not grow in the space between the preliminary semiconductor patterns 170 in the third direction D3. Thereby, while increasing the length of the preliminary semiconductor pattern 170 along the first direction D1, the node of the first electrode 310 of the data storage pattern DS may be separated. In other words, the semiconductor material layer 251 formed on the surface of one preliminary semiconductor pattern 170 and the semiconductor material layer 251 formed on the surface of another preliminary semiconductor pattern 170 positioned adjacent to it may not be connected to each other and may be spaced apart along the preliminary semiconductor pattern 170.

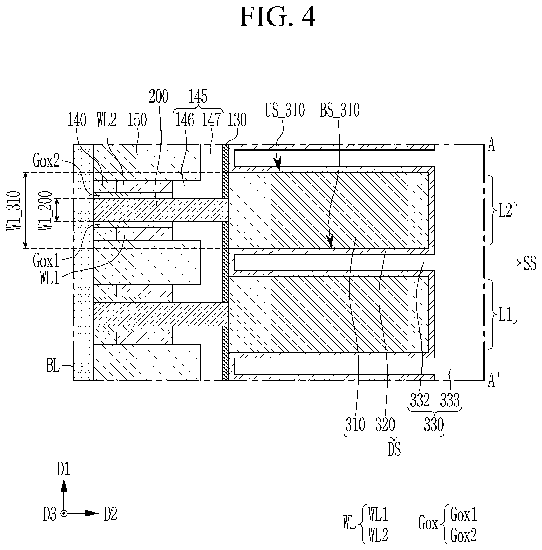

Hereinafter, referring to FIGS. 4 to 7, semiconductor devices according to various implementations will be described.

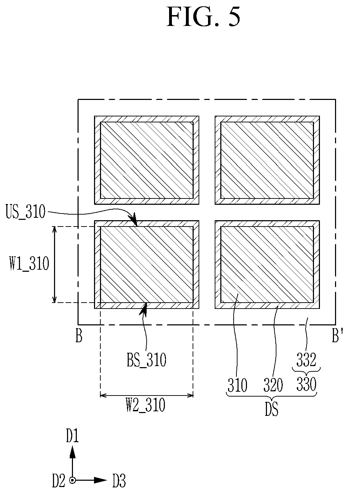

FIG. 4 is a cross-sectional view taken along line A-A' of FIG. 1, corresponding to FIG. 2. FIG. 5 is a cross-sectional view taken along the line B-B' of FIG. 1, corresponding to FIG. 3.

The implementation shown in FIGS. 4 and 5 is substantially the same as the implementation shown in FIGS. 2 and 3, so the explanation for these parts will be omitted and the differences will be primarily explained. Additionally, the same reference numerals are used for components that are the same as in the preceding implementation.

In FIGS. 2 and 3, the first electrode 310 of the data storage pattern DS may have an internal space surrounded by the first side wall 311, the second side wall 312, the third side wall 313, the fourth side wall 314, and the fifth side wall 315, and may have, for example, a cylindrical shape.

Referring to FIGS. 4 and 5, the first electrode 310 of the data storage pattern DS does not have an internal space surrounded by a first side wall 311, second side wall 312, third side wall 313, fourth side wall 314, and fifth side wall 315, but rather shows a case where it has a pillar shape with the internal space also filled with the first electrode 310.

For example, the first electrode 310 may have a first surface, a second surface BS_310, a third surface US_310, a fourth surface, a fifth surface, and a sixth surface.

The first surface and the sixth surface may be arranged spaced apart from each other in the second direction D2. The first surface may be positioned on one side of the second direction D2 of the data storage pattern DS. The sixth surface may be positioned on the other side of the second direction D2 of the data storage pattern DS. For example, the first surface and the sixth surface may be horizontal to the first direction D1 and the third direction D3. The first surface may contact the coplanar surface of the semiconductor pattern 200 and the etch stop layer 130. The sixth surface may contact the connection portion 333 of the second electrode 330. The first surface may contact one side of the second direction D2 of each of the second surface BS_310, the third surface US_310, the fourth surface, and the fifth surface. The sixth surface may be in contact with the other side in the second direction D2 of each of the second surface BS_310, the third surface US_310, the fourth surface, and the fifth surface.

The second surface BS_310 and the third surface US_310 may be arranged to be spaced apart from each other in the first direction D1. The second surface BS_310 and the third surface US_310 may respectively contact one side and the other side of the first direction D1 of the first surface and the sixth surface. The second surface BS_310 and the third surface US_310 may each extend in the second direction D2 between the first surface and the sixth surface. For example, the second side BS_310 and the third side US_310 may be horizontal with the second direction D2 and the third direction D3.

The fourth surface and the fifth surface may be arranged spaced apart from each other in the third direction D3. The fourth surface and the fifth surface may each be in contact with one side and the other side of the third direction D3 of the first surface and the sixth surface. The fourth surface and the fifth surface may each be in contact with one end and the other end of the third direction D3 of the second surface BS_310 and the third surface US_310, respectively. The fourth surface and the fifth surface may each extend in the second direction D2 between the first surface and the sixth surface. In addition, the fourth surface and the fifth surface may each extend in the first direction D1 between the second surface BS_310 and the third surface US_310. For example, the fourth surface and the fifth surface may be horizontal with the first direction D1 and the second direction D2.

For example, the space surrounded by the first surface, the second surface BS_310, the third surface US_310, the fourth surface, the fifth surface, and the sixth surface of the first electrode 310 may all be filled with the same material. In other words, the first electrode 310 may have a pillar shape that extends in the second direction D2.

The second electrode 330 may have an outer portion 332 and a connection portion 333.

In other words, as the first electrode 310 does not have an internal space, the second electrode 330 may not have an inner portion 331.

The outer portion 332 may be positioned outside the first electrode 310. The outer portion 332 may surround the first electrode 310. For example, the outer portion 332 may be in contact with the second surface BS_310, the third surface US_310, the fourth surface, and the fifth surface of the first electrode 310. The outer portion 332 may extend in the second direction D2 along the second surface BS_310, the third surface US_310, the fourth surface, and the fifth surface of the first electrode 310.

The connection portion 333 may be positioned on the other side of the first electrode 310 in the second direction D2. The connection portion 333 may contact the other side of the sixth surface of the first electrode 310 in the second direction D2. The connection portion 333 may contact the other side of the outer portion 332 in the second direction D2. The connection portion 333 may connect the plurality of outer portions 332 by extending along the stacking structure SS in the first direction D1. As a result, the data storage patterns DS of a plurality of layers stacked in a first direction D1 may share a single second electrode 330.

The dielectric layer 320 may be positioned between the first electrode 310 and the second electrode 330. The dielectric layer 320 may conformally cover the first electrode 310. In other words, the dielectric layer 320 may be a thin film having a uniform thickness along the shape of the other surface of the first electrode 310 in the second direction D2.

The dielectric layer 320 may cover the outside of the first electrode 310. In other words, the dielectric layer 320 may cover one side of the second surface BS_310 of the first electrode 310 in the first direction D1. The dielectric layer 320 may cover one side of the third surface US_310 of the first electrode 310 in the first direction D1. The dielectric layer 320 may cover one side of the fourth surface of the first electrode 310 in the third direction D3. The dielectric layer 320 may cover the other side of the fifth face of the first electrode 310 in the third direction D3. The dielectric layer 320 may cover the other side of the sixth surface of the first electrode 310 in the second direction D2.

The dielectric layer 320 may surround the first electrode 310. The dielectric layer 320 may be surrounded by the second electrode 330.

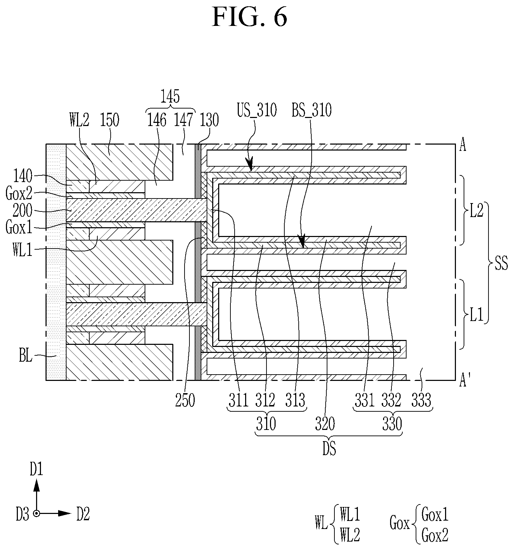

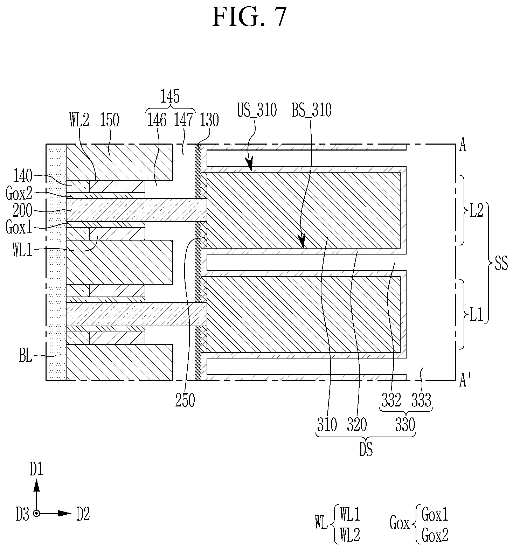

FIG. 6 is a cross-sectional view taken along line A-A' of FIG. 1, corresponding to FIG. 2. FIG. 7 is a cross-sectional view taken along line A-A' of FIG. 1, corresponding to FIG. 4.

The implementation shown in FIGS. 6 and 7 is substantially the same as the implementation shown in FIGS. 2 and 4, so the explanation for these parts will be omitted and the differences will be primarily explained. Additionally, the same reference numerals are used for components that are the same as in the preceding implementation.

Referring to FIGS. 6 and 7, a semiconductor layer 250 may be positioned between the word line WL and the first electrode 310 of the data storage pattern DS. The semiconductor layer 250 may be positioned between the etch stop layer 130 and the first electrode 310 of the data storage pattern DS. One surface of the semiconductor layer 250 in the second direction D2 may be in contact with the etch stop layer 130. The semiconductor layer 250 may conformally cover the other surface of the etch stop layer 130 in the second direction D2. In other words, the semiconductor layer 250 may be a thin film having a uniform thickness along the surface shape on the other side of the etch stop layer 130 in the second direction D2.

The other surface of the semiconductor layer 250 in the second direction D2 may be in contact with the data storage pattern DS. The other surface of the semiconductor layer 250 in the second direction D2 may contact with the first electrode 310 of the data storage pattern DS.

The semiconductor layer 250 may overlap with the dielectric layer 320 or the second electrode 330 of the data storage pattern DS in the first direction D1. The semiconductor layer 250 may overlap with the first electrode 310 of the data storage pattern DS in the second direction D2.

The semiconductor layer 250 may have an upper semiconductor layer portion positioned above the first direction D1 of the semiconductor pattern 200 and a lower semiconductor layer portion positioned below the first direction D1 of the semiconductor pattern 200. In other words, the semiconductor layer 250 may be arranged spaced apart in the first direction D1 with the semiconductor pattern 200 in between.

Additionally, the semiconductor layer 250 may overlap with the other end in the second direction D2 of the semiconductor pattern 200 in the first direction D1. The semiconductor layer 250 may directly contact the other end of the semiconductor pattern 200 in the second direction D2. The semiconductor layer 250 may contact the other end of the second direction D2 on the upper surface and the lower surface of the semiconductor pattern 200 in the first direction D1. The semiconductor layer 250 and one end of the semiconductor pattern 200 in the second direction D2 may form a coplanar surface. Accordingly, the other side of the semiconductor pattern 200 in the second direction D2 may contact the first electrode 310 of the data storage pattern DS by penetrating through the semiconductor layer 250. In other words, one side of the first electrode 310 of the data storage pattern DS in the second direction D2 may simultaneously contact the other end of the semiconductor pattern 200 in the second direction D2 and the semiconductor layer 250.

The semiconductor layer 250 may include the same material as the semiconductor pattern 200. Therefore, the semiconductor layer 250 may include semiconductor material. For example, the semiconductor layer 250 may include monocrystalline silicon. In some implementations, the semiconductor layer 250 may include an oxide semiconductor material. The oxide semiconductor material may be combined with at least 2 or more of In, Ga, Zn, Al, Sn, and Hf, but is not limited thereto. The oxide semiconductor material may also include materials such as Si, Mg, Ta, La, Nd, Ce, Sc, Cr, Co, Nb, Mo, Ba, Gd, Ti, W, Pd, Ru, Ni, or Mn in the composition. For example, the semiconductor pattern 200 may include IGZO (indium gallium zinc oxide), ITZO (indium tin zinc oxide), IZO (indium zinc oxide), ZnO (zinc oxide), ZTO (zinc tin oxide), ZnON (zinc oxynitride), ZZTO (zirconium zinc tin oxide), SnO (tin oxide), HIZO (hafnium indium zinc oxide), GZTO (gallium zinc tin oxide), AZTO (aluminium zinc tin oxide), YGZO (ytterbium gallium zinc oxide), IGO (indium gallium oxide), or a combination thereof.

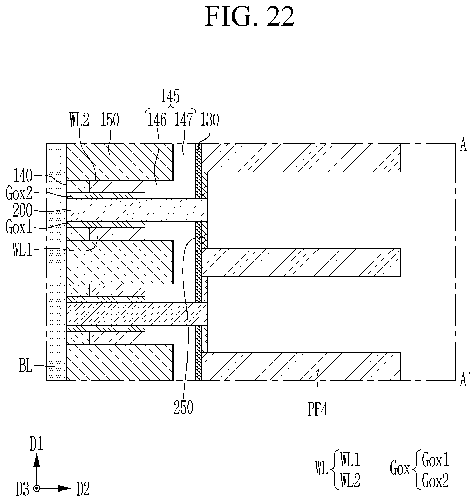

As described later in FIG. 22, when removing part of the preliminary semiconductor pattern 170 and the semiconductor material layer 251, a portion of the semiconductor material layer 251 may remain on the surface of the etch stop layer 130 in the second direction D2, forming the semiconductor layer 250 that is positioned between the word line WL and the first electrode 310 of the data storage pattern DS and contacts the semiconductor pattern 200.

The semiconductor layer 250 connects between the semiconductor pattern 200 and the first electrode 310 of the data storage pattern DS, which may increase the contact area between the semiconductor pattern 200 and the first electrode 310 of the data storage pattern DS.

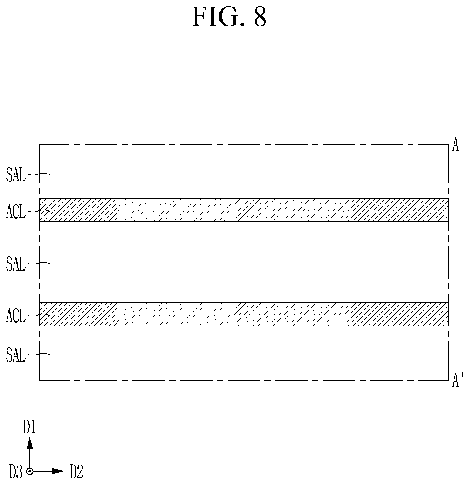

Hereinafter, referring to FIGS. 8 to 38, a method for manufacturing a semiconductor device will be described.

FIGS. 8 to 30 are cross-sectional views showing a method for manufacturing a semiconductor device according to an implementation in process order. FIGS. 8 to 30 illustrate a method for manufacturing the semiconductor device according to FIGS. 1 to 3.

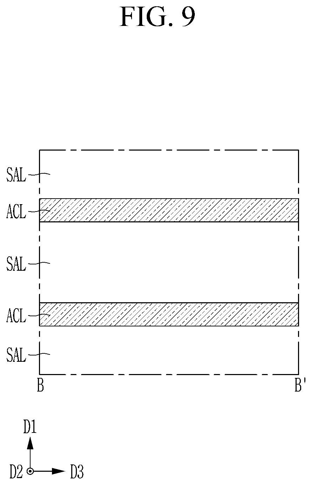

FIG. 8 is a cross-sectional view taken along line A-A' of FIG. 1, corresponding to FIG. 2. Figure 9 is a cross-sectional view taken along the line B-B' of Figure 1, corresponding to Figure 3.

Referring to FIGS. 8 and 9, sacrificial layers SAL and active layers ACL may be alternately stacked on the substrate 110. Each of the sacrificial layers SAL and the active layers ACL may include semiconductor material. The sacrificial layers SAL may include materials that have etch selectivity with the active layers ACL. Accordingly, during the subsequent removal process of the sacrificial layers SAL, even when the sacrificial layers SAL are removed, the active layers ACL may remain unremoved or may be less removed. For example, the active layers ACL may include silicon (Si), germanium (Ge), or silicon-germanium (SiGe), and the sacrificial layers SAL may include one of silicon (Si), germanium (Ge), or silicon-germanium (SiGe) that is different from the active layers ACL. For example, the active layers ACL may include silicon (Si), and the sacrificial layers SAL may include silicon-germanium (SiGe). The thickness of the sacrificial layers SAL may be greater than the thickness of the active layers ACL.

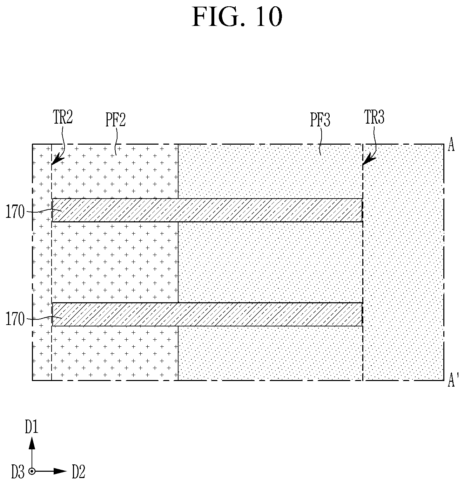

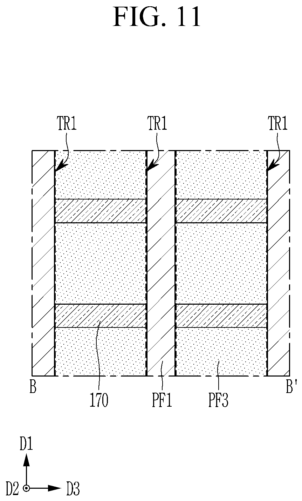

Fig. 10 is a cross-sectional view taken along line A-A' of Fig. 1, corresponding to Fig. 2. FIG. 11 is a cross-sectional view taken along the line B-B' of FIG. 1, corresponding to FIG. 3.

Referring to FIGS. 10 and 11, preliminary semiconductor patterns 170 spaced apart in the first direction D1 are formed.

First, the sacrificial layers SAL and the active layers ACL may be patterned to form first trenches TR1. The first trenches TR1 may extend in the second direction D2, and may be formed to be spaced apart from each other along the second direction D2 and the third direction D3. The first trenches TR1 are formed from the uppermost sacrificial layer SAL or the uppermost active layer ACL to the substrate 110 in the first direction D1, allowing a portion of the upper surface of the substrate 110 to be exposed to the outside.

Forming the first trenches TR1, the sacrificial layers SAL remaining after patterning may constitute the first sacrificial patterns, and the active layers ACL remaining after patterning may constitute preliminary active patterns. The first sacrificial patterns and the preliminary active patterns may include regions extending in the second direction D2 between the first trenches TR1 spaced apart from each other in the third direction D3, and regions extending in the third direction D3 intersecting with regions extending in the second direction D2.

After forming the first trenches TR1, first preliminary filling patterns PF1 may fill the first trenches TR1. The first preliminary filling patterns PF1 may cover the upper surface of the exposed substrate 110. The preliminary filling patterns PF1 may be spaced apart from each other in the second direction D2 and the third direction D3 by preliminary active patterns and the first sacrificial patterns. For example, the first preliminary filling pattern PF1 may include insulating material.

Next, after forming the first preliminary filling patterns PF1, a second trench TR2 may be formed. The second trench TR2 may be formed on one side of the first sacrificial patterns and the preliminary active patterns in the second direction D2, and may extend along the third direction D3.

For example, the second trench TR2 may be formed by patterning a portion of a region extending in the third direction D3 among the first sacrificial patterns and the preliminary active patterns on the plane. In some implementations, when forming the second trench TR2, a portion of the upper part of the substrate 110 may be removed.

Forming the second trench TR2, the preliminary active patterns remaining after patterning may constitute active patterns. The second trench TR2 may expose one side of the first sacrificial patterns, the active patterns, and the first preliminary filling patterns PF1 in the second direction D2 to the outside. The second trench TR2 may expose some of the upper surface of the substrate 110 to the outside.

After forming the second trench TR2, one side in the second direction D2 of the first sacrificial patterns exposed by the second trench TR2 may be selectively removed through a selective etching process. Through a selectively etching process, the first sacrificial patterns that remain after removal may constitute the second sacrificial patterns. During the selectively etching process, a portion of each of the first preliminary filling patterns PF1 may be removed together, exposing part of the upper surface of substrate 110. The side walls in the second direction D2 of the preliminary filling patterns PF1 may be aligned with the side walls in the second direction D2 of the second sacrificial patterns.

As one side of the first sacrificial patterns in the second direction D2 is selectively removed, first internal regions may be formed between neighboring active patterns along the first direction D1.

For example, selectively removing one side in the second direction D2 of the first sacrificial patterns exposed by the second trench TR2 may include forming a mask pattern on the first preliminary filling pattern PF1 and the active pattern, and removing a portion of one side in the second direction D2 of the first preliminary filling pattern PF1 and the first sacrificial patterns through a selective etching process.

After selectively removing one side of the second direction D2 of the first sacrificial patterns exposed by the second trench TR2, the second preliminary filling pattern PF2 may fill the first inner regions and the upper surface of the exposed substrate 110. The second preliminary filling pattern PF2 may surround and cover active patterns that do not vertically overlap with second sacrificial patterns. The second preliminary filling pattern PF2 may include a single membrane or composite membrane containing insulating material. As one example, the second preliminary filling pattern PF2 may include silicon oxide, silicon nitride, or a combination thereof. For example, the second preliminary filling pattern PF2 may include a material that may have etch selectivity with respect to the first preliminary filling pattern PF1.

Next, after forming the second preliminary filling pattern PF2, a third trench TR3 may be formed. The third trench TR3 may be formed on the other side of the second sacrificial patterns and active patterns in the second direction D2, and may extend along the third direction D3. For example, the third trench TR3 may be formed by patterning second sacrificial patterns and active patterns that extend in the third direction D3, thereby exposing a portion of the upper surface of substrate 110. In some implementations, a third trench TR3 is formed, and a portion of the substrate 110 above corresponding to the third trench TR3 may be removed.

Through the selectively etching process, the remaining active patterns after removal may constitute preliminary semiconductor patterns 170. The third trench TR3 may expose the other side of the preliminary semiconductor patterns 170 in the second direction D2 to the outside.

After forming the third trench TR3, all the second sacrificial patterns may be removed through an etching process. Accordingly, second internal regions may be formed between the first direction D1 of the preliminary semiconductor patterns 170. The second internal regions may vertically overlap with regions of preliminary semiconductor patterns 170 that do not overlap with the second preliminary filling pattern PF2.

In some implementations, when removing the second sacrificial patterns, the first preliminary filling patterns PF1 may be removed together. Through the etching process, all first preliminary filling patterns PF1 may be removed. However, as described later in FIG. 16, in the space surrounded by the preliminary semiconductor pattern 170, the etch stop layer 130, and the first preliminary filling pattern PF1, in order to grow the semiconductor material layer 251 only on the surface of the preliminary semiconductor pattern 170 by a selective epitaxial growth method, the first preliminary filling pattern PF1 may not be removed.

After removing the second sacrificial patterns, a third preliminary filling pattern PF3 may be formed to fill the second inner regions and the inside of the third trench TR3. The third preliminary filling pattern PF3 may include a single film or composite film containing insulating material. As an example, the third preliminary filling pattern PF3 may include silicon oxide, silicon nitride, or a combination thereof.

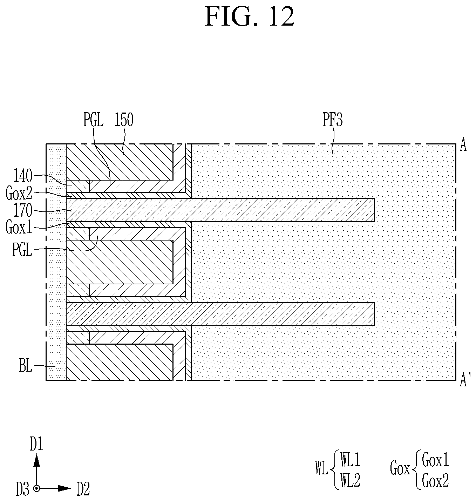

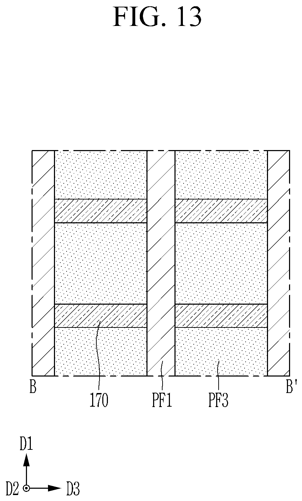

FIG. 12 is a cross-sectional view taken along line A-A' of FIG. 1, corresponding to FIG. 2. FIG. 13 is a cross-sectional view taken along line B-B' of FIG. 1, corresponding to FIG. 3.

Referring to FIGS. 12 and 13, a preliminary stack is formed including a bit line BL extending in the first direction D1, a preliminary semiconductor patterns 170 with one end connected to the bit line BL and spaced apart in the first direction D1, and a word line WL extending in the third direction D3 and positioned on one side of the preliminary semiconductor pattern 170 in the first direction D1.

First, the second preliminary filling pattern PF2 may be removed. Accordingly, a portion of the upper surface of the substrate 110, a portion of one side in the second direction D2 of the preliminary semiconductor patterns 170, and a portion of one side in the second direction D2 of the third preliminary filling pattern PF3 may be exposed to the outside. For example, the second preliminary filling pattern PF2 may be removed through a selectively etching process.

After removing the second preliminary filling pattern PF2, a gate insulation layer Gox and a preliminary gate electrode layer PGL may be sequentially formed within the first internal regions. Each gate insulation layer Gox may cover a portion of the preliminary semiconductor pattern 170 with a uniform thickness, and the preliminary gate electrode layer PGL may cover the gate insulation layer Gox with a uniform thickness. The preliminary gate electrode layer PGL may be formed with a uniform thickness along the upper surface and bottom surface in the first direction D1 of the preliminary semiconductor patterns 170, which are spaced apart in the first direction D1, and along one side in the second direction D2 of the third preliminary filling pattern PF3. Additionally, the preliminary gate electrode layer PGL may surround the preliminary semiconductor patterns 170, which are spaced apart in the third direction D3, and may extend in the third direction D3.

For example, forming a gate insulation layer Gox and a preliminary gate electrode layer PGL may include forming the gate insulation layer Gox on one side of the exposed preliminary semiconductor patterns 170 and the third preliminary filling pattern PF3 in the second direction D2 through a deposition process, forming the preliminary gate electrode layer PGL on the gate insulation layer Gox through a deposition process, forming a word line separation layer 150 between the preliminary gate electrode layers PGL through a deposition process, and patterning parts of the gate insulation layer Gox and the preliminary gate electrode layer PGL. In other words, the preliminary gate electrode layer PGL may fill a portion of the region between the preliminary semiconductor patterns 170 that are spaced apart in the first direction D1, and the word line separation layer 150 may fill the remaining region.

In some implementations, when patterning a portion of the preliminary gate electrode layer PGL, one side of the preliminary gate electrode layer PGL in the second direction D2 may be recessed further than one side of the word line separation layer 150 in the second direction D2, and a spacer 140 may be formed in the space where the preliminary gate electrode layer PGL is recessed.

For example, the gate insulation layer Gox and preliminary gate electrode layer PGL may be formed by PVD (Physical Vapor Deposition), CVD (Chemical Vapor Deposition), or ALD (Atomic Layer Deposition) process. For example, the etching process may be a wet etching process.

After forming the gate insulation layer Gox and the preliminary gate electrode layer PGL, a buried insulation pattern may fill the first internal regions and the region where the second preliminary filling pattern PF2 has been removed through a deposition process.

After forming the buried insulation pattern, a bit line BL may be formed to penetrate through the buried insulation pattern and to contact one side of the preliminary semiconductor patterns 170 in the second direction D2. For example, forming the bit line BL may include patterning the buried insulation pattern to form a trench, and forming the bit line BL that fills the trench.

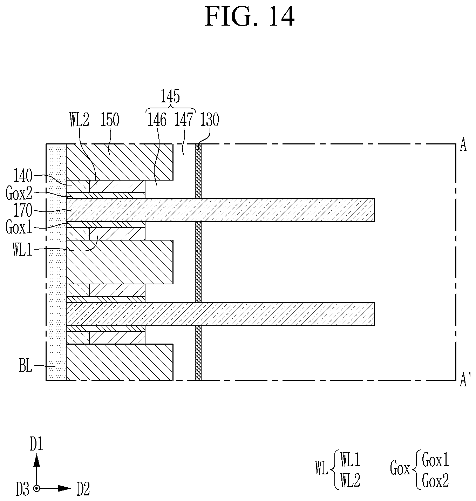

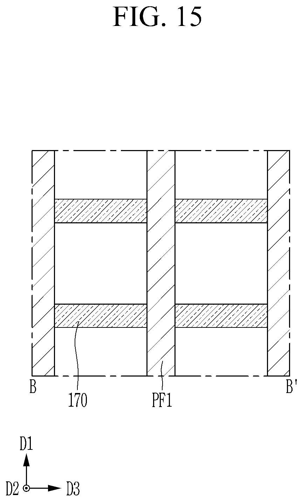

FIG. 14 is a cross-sectional view taken along line A-A' of FIG. 1, corresponding to FIG. 2. FIG. 15 is a cross-sectional view taken along line B-B' of FIG. 1, corresponding to FIG. 3.

Referring to FIGS. 14 and 15, the preliminary gate electrode layer PGL is separated to form the word lines WL, a capping pattern 145 is formed to cover the other end of the word lines WL in the second direction D2, and an etch stop layer 130 is formed at the other end of the capping pattern 145 in the second direction D2.

First, the third preliminary filling pattern PF3 may be removed. For example, the third preliminary filling pattern PF3 may be removed through a selective etching process.

After removing the third preliminary filling pattern PF3, the gate insulation layer Gox may be separated. For example, part of the gate insulation layer Gox that was in contact with one side of the second direction D2 of the third preliminary filling pattern PF3 may be removed and separated through an etching process. Thereby, the gate insulation layers Gox may be spaced apart from each other in the first direction D1 and the third direction D3, and may surround the corresponding the preliminary semiconductor patterns 170.

After removing part of the gate insulation layer Gox, the preliminary gate electrode layer PGL may be separated to form the word line WL. For example, a portion of the preliminary gate electrode layer PGL that was in contact with the removed gate insulation layer Gox may be removed and separated through an etching process. Thereby, the word lines WL may be spaced apart from each other in the first direction D1, and the word line WL may extend in the third direction D3 across the preliminary semiconductor patterns 170 and the gate insulation layers Gox that are spaced apart in the third direction D3. The word lines WL may be separated from each other in a first direction D1 by the word line separation layer 150, and may enclose corresponding the preliminary semiconductor patterns 170 and the gate insulation layers Gox.

Next, a capping pattern 145 may be formed to cover the other side of the word line WL and the word line separation layer 150 in the second direction D2.

The capping pattern 145 may be formed to flatten the surface on the opposite side of the word line WL and the word line separation layer 150 in the second direction D2.

The capping pattern 145 may be formed on the other side of the etch stop layer 130 in the second direction D2. The etch stop layer 130 may be formed to conformally cover the other surface of the capping pattern 145 in the second direction D2.

For example, the capping pattern 145 and the etch stop layer 130 may be formed through a deposition process.

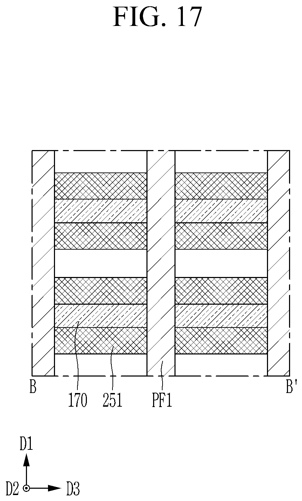

FIG. 16 is a cross-sectional view taken along line A-A' of FIG. 1, corresponding to FIG. 2. FIG. 17 is a cross-sectional view taken along line B-B' of FIG. 1, corresponding to FIG. 3.

Referring to FIGS. 16 and 17, a semiconductor material layer 251 is grown on the other side of the preliminary semiconductor pattern 170 in the second direction D2.

The other end of the preliminary semiconductor pattern 170 in the second direction D2 may be exposed in a space from which the third preliminary filling pattern PF3 has been removed. For example, the other side of the preliminary semiconductor pattern 170 in the second direction D2 may penetrate through the etch stop layer 130 and be exposed. The first preliminary filling pattern PF1 may be positioned on both sides in the third direction D3 of the exposed preliminary semiconductor pattern 170. The both sides of the exposed preliminary semiconductor pattern 170 in the third direction D3 may contact the first preliminary filling pattern PF1.

A semiconductor material layer 251 may be grown in a space surrounded by the preliminary semiconductor pattern 170, the etch stop layer 130, and the first preliminary filling pattern PF1, using a Selective Epitaxial Growth (SEG) method with the preliminary semiconductor pattern 170 as a seed.

At this time, the preliminary semiconductor pattern 170, the etch stop layer 130, and the first preliminary filling pattern PF1 may include different materials. In other words, the preliminary semiconductor pattern 170, the etch stop layer 130, and the first preliminary filling pattern PF1 may form a heterogeneous interface. Therefore, using the selective epitaxial growth method, the semiconductor material layer 251 may be formed only on the upper surface and lower surface of the preliminary semiconductor pattern 170 in the first direction D1.

The semiconductor material layer 251 may not grow on the surface of the etch stop layer 130 and the surface of the first preliminary filling pattern PF1. Therefore, only the length in the first direction D1 of the preliminary semiconductor pattern 170 may be increased.

Additionally, since the semiconductor material layer 251 does not grow on the surface of the first preliminary filling pattern PF1, the semiconductor material layer 251 formed on the surface of one preliminary semiconductor pattern 170 and the semiconductor material layer 251 formed on the surface of another preliminary semiconductor pattern 170 located adjacent to it in the first direction D1 may not be connected to each other along the surface of the first preliminary filling pattern PF1, and may be spaced apart from each other in the first direction D1. In this way, the node of the first electrode 310 of the data storage pattern DS may be separated.

For example, the selective epitaxial growth method (SEG) may include a process of introducing a source gas through a space where the third preliminary filling pattern PF3 has been removed, into a space exposed between the etch stop layer 130 and the first preliminary filling pattern PF1 at the other side in the second direction D2 of the preliminary semiconductor pattern 170. For example, the interior of the chamber in which the substrate 110 is loaded may be adjusted to a pressure lower than atmospheric pressure using a vacuum pump or a similar device, and the substrate 110 may be heated to a predetermined temperature. After heating the substrate 110, the source gas is introduced into the space where the other side of the preliminary semiconductor pattern 170 in the second direction D2 is exposed. Here, the source gas may include a source gas for forming a semiconductor material layer 251, for example, a silicon source gas, a germanium source gas, or a combination thereof. The source gas may be decomposed by thermal energy, generating silicon nuclei, germanium nuclei, or silicon-germanium (SiGe) nuclei. Accordingly, silicon nuclei, germanium nuclei, or silicon germanium nuclei may bond with dangling bonds on the surface of the preliminary semiconductor pattern 170, and thus may be adsorbed onto the surface of the preliminary semiconductor pattern 170, thereby growing the semiconductor material layer 251.

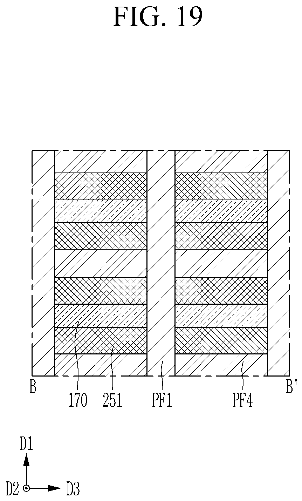

FIG. 18 is a cross-sectional view taken along line A-A' of FIG. 1, corresponding to FIG. 2. FIG. 19 is a cross-sectional view taken along the line B-B' of FIG. 1, corresponding to FIG. 3.

Referring to FIGS. 18 and 19, fourth preliminary filling patterns PF4 may be formed between the preliminary semiconductor patterns 170 on which the semiconductor material layer 251 is formed on the surface.

As described above, the semiconductor material layer 251 formed on the surface of one preliminary semiconductor pattern 170 and the semiconductor material layer 251 formed on the surface of another preliminary semiconductor pattern 170 positioned adjacent to it in the first direction D1 are not connected to each other, and as they are spaced apart from each other in the first direction D1, an empty space may be formed between the preliminary semiconductor patterns 170 on whose surfaces the semiconductor material layer 251 is formed, and the fourth preliminary filling patterns PF4 may fill the empty space.

For example, the fourth preliminary filling patterns PF4 may be formed by a deposition process. The preliminary filling patterns PF4 may include a single film or composite film containing insulating material. For example, the fourth preliminary filling patterns PF4 may include silicon oxide, silicon nitride, or a combination thereof.

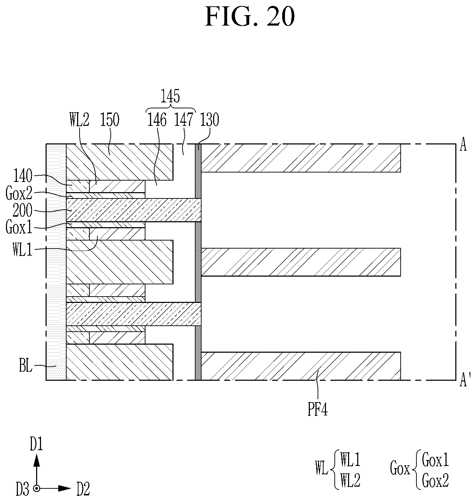

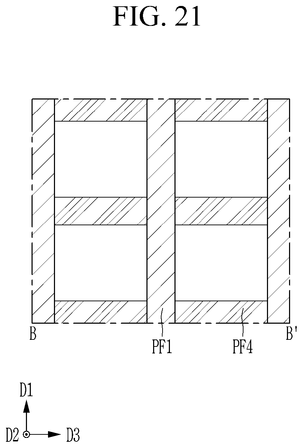

FIG. 20 is a cross-sectional view taken along line A-A' of FIG. 1, corresponding to FIG. 2. FIG. 21 is a cross-sectional view taken along line B-B' of FIG. 1, corresponding to FIG. 3. FIG. 22 is a cross-sectional view taken along line A-A' of FIG. 1, showing another implementation.

Referring to FIGS. 20 and 21, a portion of the preliminary semiconductor pattern 170 and the semiconductor material layer 251 are removed.

For example, through a selectively etching process, a part of the preliminary semiconductor pattern 170 and the semiconductor material layer 251 may be selectively removed. The preliminary semiconductor pattern 170, which remains after being removed through a selectively etching process, may constitute the semiconductor pattern 200. Additionally, a portion of the preliminary semiconductor pattern 170 and the semiconductor material layer 251 may be removed, and an empty space may be formed in the space surrounded by the first preliminary filling patterns PF1 and the fourth preliminary filling patterns PF4.

For example, the selectively etching process may be a time etch that proceeds for an appropriate amount of time until the semiconductor material layer 251 is completely removed and the etch stop layer 130 is exposed. Thereby, the other side of the semiconductor pattern 200 in the second direction D2 and the etch stop layer 130 may form a coplanar surface.

However, when removing part of the preliminary semiconductor pattern 170 and the semiconductor material layer 251, due to time etching, a portion of the semiconductor material layer 251 may remain on the second direction D2 surface of the etch stop layer 130.

Accordingly, as shown in FIG. 22, a semiconductor layer 250 may be formed on one surface of the etch stop layer 130 in the second direction D2. The other surface of the semiconductor layer 250 in the second direction D2 may be in contact with the first electrode 310 of the data storage pattern DS, and the semiconductor layer 250 may directly contact the other end of the semiconductor pattern 200 in the second direction D2. In other words, the other ends of the semiconductor layer 250 and the semiconductor pattern 200 in the second direction D2 may be coplanar, and may contact the first electrode 310 of the data storage pattern DS. The semiconductor layer 250 connects between the semiconductor pattern 200 and the first electrode 310 of the data storage pattern DS, which may increase the contact area between the semiconductor pattern 200 and the first electrode 310 of the data storage pattern DS.

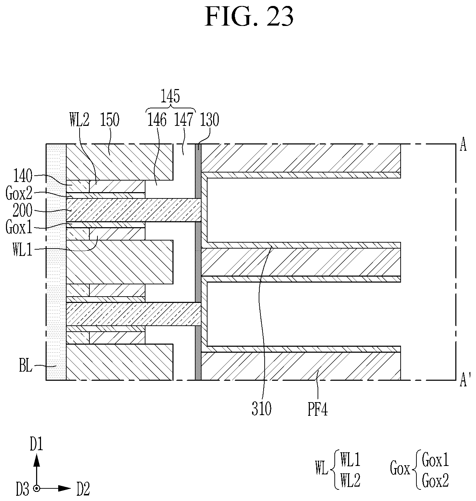

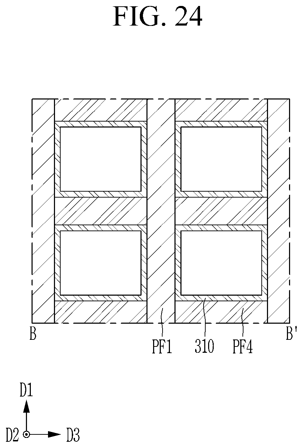

FIG. 23 is a cross-sectional view taken along line A-A' of FIG. 1, corresponding to FIG. 2. FIG. 24 is a cross-sectional view taken along line B-B' of FIG. 1, corresponding to FIG. 3.

Referring to FIGS. 23 and 24, a first electrode 310 of a data storage pattern DS is formed in a space where a portion of the preliminary semiconductor pattern 170 and the semiconductor material layer 251 have been removed.

As described above, a portion of the preliminary semiconductor pattern 170 and the semiconductor material layer 251 are removed, and an empty space may be formed in the space surrounded by the first preliminary filling patterns PF1 and the fourth preliminary filling patterns PF4.

The first electrode 310 of the data storage pattern DS may be formed in a space surrounded by the first preliminary filling patterns PF1 and the fourth preliminary filling patterns PF4. The first electrode 310 may be conformally formed within an empty space surrounded by the first preliminary filling pattern PF1 and the fourth preliminary filling pattern PF4. In other words, the first electrode 310 may be formed as a thin film with a uniform thickness along the surface shape within an empty space surrounded by the first preliminary filling patterns PF1 and the fourth preliminary filling patterns PF4. Additionally, the first electrode 310 may be conformally formed on the coplanar surface formed by the semiconductor pattern 200 and the etch stop layer 130.

For example, the first electrode 310 may be deposited by an ALD process, but is not limited thereto.

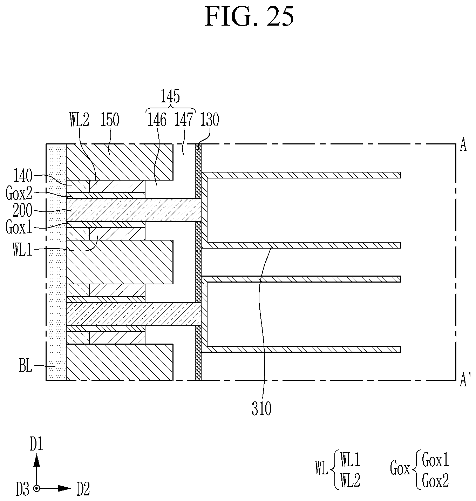

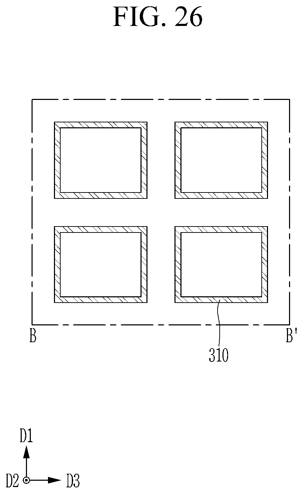

FIG. 25 is a cross-sectional view taken along line A-A' of FIG. 1, corresponding to FIG. 2. FIG. 26 is a cross-sectional view taken along line B-B' of FIG. 1, which corresponds to FIG. 3.

Referring to FIGS. 25 and 26, the first preliminary filling patterns PF1 and the fourth preliminary filling patterns PF4 may be removed.

For example, the first preliminary filling patterns PF1 and the fourth preliminary filling patterns PF4 may be removed through a selective etching process. Through the removal of the first preliminary filling patterns PF1 and the fourth preliminary filling patterns PF4, the external surface of the first electrode 310 may be exposed.

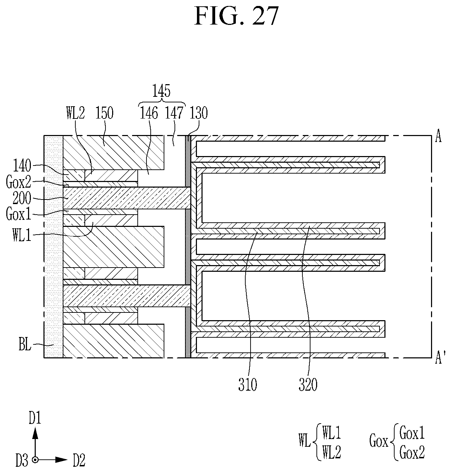

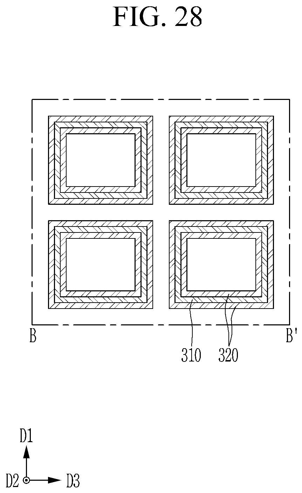

FIG. 27 is a cross-sectional view taken along line A-A' of FIG. 1, corresponding to FIG. 2. FIG. 28 is a cross-sectional view taken along line B-B' of FIG. 1, corresponding to FIG. 3.

Referring to FIGS. 27 and 28, a dielectric layer 320 is formed on the surface of the first electrode 310.

The dielectric layer 320 may be formed on the inner surface and outer surface of the first electrode 310. Also, the dielectric layer 320 may be formed on the other surface of the etch stop layer 130 in the second direction D2 between the first electrodes 310.

The dielectric layer 320 may be conformally formed on the first electrode 310. In other words, the dielectric layer 320 may be formed as a thin film having a uniform thickness that follows the surface shape of the first electrode 310.

For example, the dielectric layer 320 may be deposited by an ALD process, but is not limited thereto.

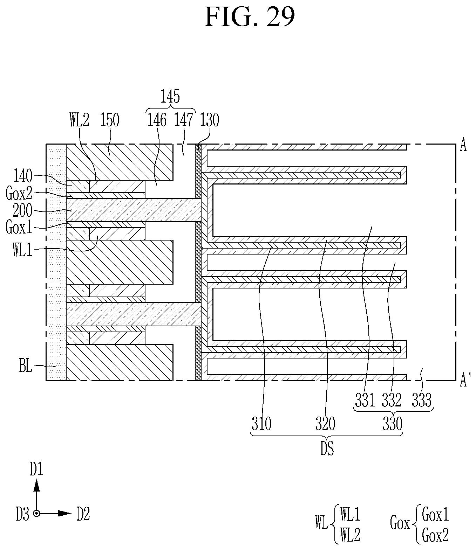

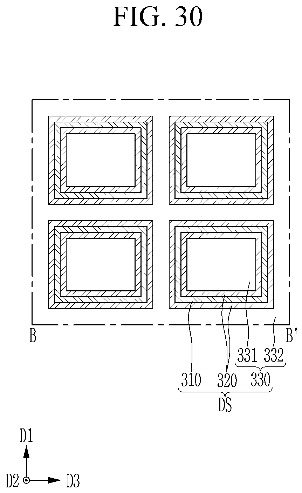

FIG. 29 is a cross-sectional view taken along line A-A' of FIG. 1, corresponding to FIG. 2. FIG. 30 is a cross-sectional view taken along line B-B' of FIG. 1, corresponding to FIG. 3.

Referring to FIGS. 29 and 30, a second electrode 330 is formed on the dielectric layer 320.

The second electrode 330 may be formed to fill the interior space and exterior space of the first electrode 310 with the dielectric layer 320 in between. Also, the second electrode 330 may be formed to fill the space where the third preliminary filling pattern PF3 has been removed.

For example, the second electrode 330 may be formed by a PVD or CVD process, but is not limited thereto.

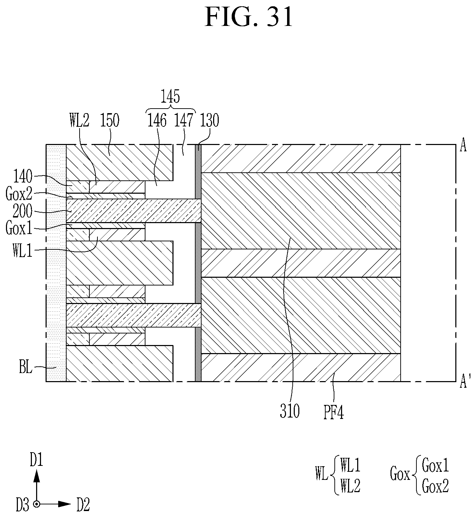

FIGS. 31 to 38 are cross-sectional views showing a method for manufacturing a semiconductor device in process order, representing another implementation.

FIGS. 31 to 38 show a method for manufacturing the semiconductor device according to FIGS. 4 and 5.

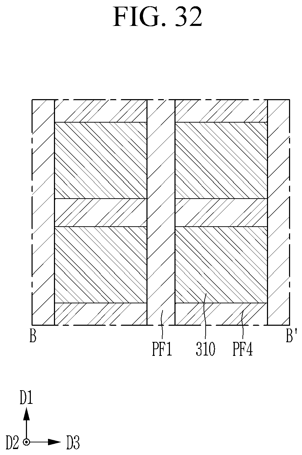

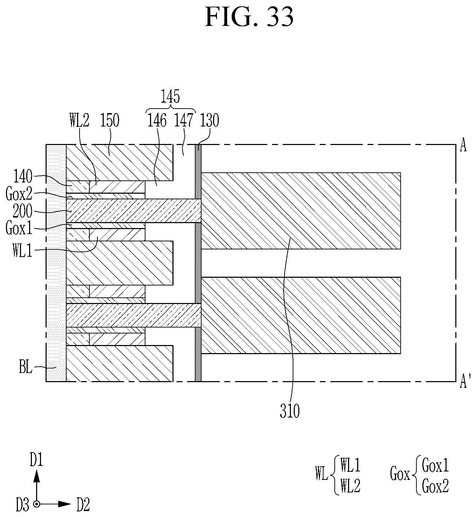

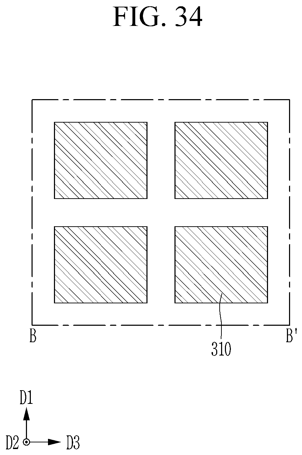

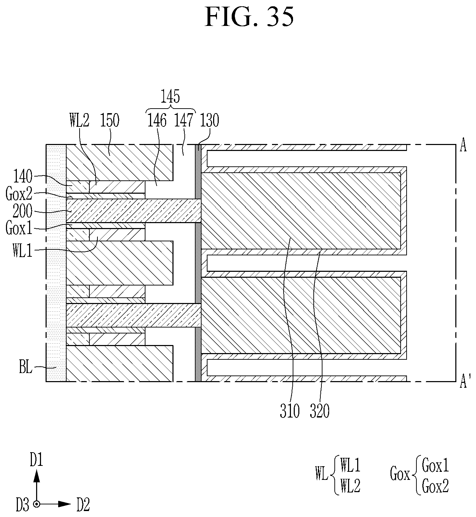

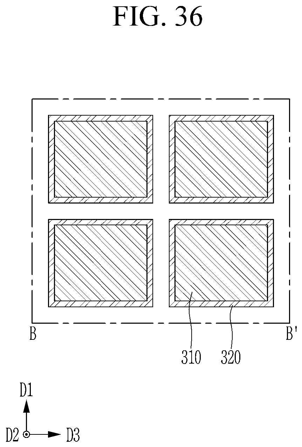

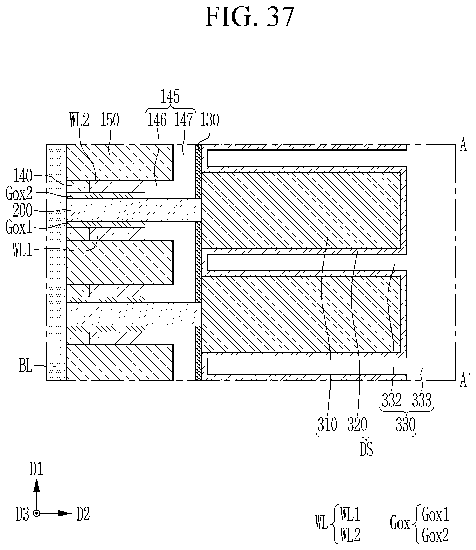

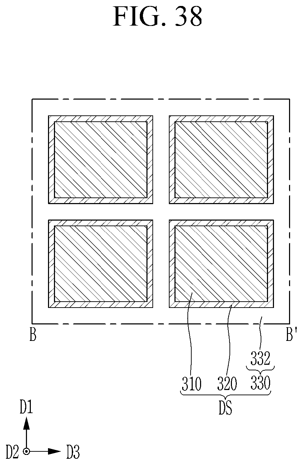

FIG. 31 is a cross-sectional view taken along line A-A' of FIG. 1, corresponding to FIG. 23. FIG. 32 is a cross-sectional view taken along line B-B' of FIG. 1, corresponding to FIG. 24. FIG. 33 is a cross-sectional view taken along line A-A' of FIG. 1, corresponding to FIG. 25. FIG. 34 is a cross-sectional view taken along line B-B' of FIG. 1, corresponding to FIG. 26. FIG. 35 is a cross-sectional view taken along line A-A' of FIG. 1, corresponding to FIG. 27. FIG. 36 is a cross-sectional view taken along line B-B' of FIG. 1, corresponding to FIG. 28. FIG. 37 is a cross-sectional view taken along line A-A' of FIG. 1, corresponding to FIG. 29. FIG. 38 is a cross-sectional view taken along line B-B' of FIG. 1, corresponding to FIG. 30.

The implementation shown in FIGS. 31 to 38 is substantially the same as the implementation shown in FIGS. 23 to 30, so the explanation for these parts will be omitted and the differences will be primarily explained. Additionally, the same reference numerals are used for components that are the same as in the preceding implementation.

Referring to FIGS. 31 to 38, when forming the first electrode 310 of the data storage pattern DS in the space where a part of the preliminary semiconductor pattern 170 and the semiconductor material layer 251 are removed, the first electrode 310 may be formed to fill the empty space surrounded by the first preliminary filling patterns PF1 and the fourth preliminary filling patterns PF4. In other words, the first electrode 310 is not conformally formed in the empty space, and accordingly, the internal space of the first electrode 310 is not formed.

The first preliminary filling patterns PF1 and the fourth preliminary filling patterns PF4 are removed, and the dielectric layer 320 is formed on the surface of the first electrode 310. The dielectric layer 320 may be conformally formed on the first electrode 310. However, the dielectric layer 320 is formed on the outer surface of the first electrode 310, and not formed on the inner surface of the first electrode 310.

The second electrode 330 is formed on the dielectric layer 320. The second electrode 330 may be formed to fill the outer space of the first electrode 310 with the dielectric layer 320 in between. Also, the second electrode 330 may be formed to fill the space where the third preliminary filling pattern PF3 has been removed. However, the second electrode 330 is not formed to fill the internal space of the first electrode 310 with the dielectric layer 320 in between.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a bit line (BL) extending in a first direction (D1);
a plurality of semiconductor patterns spaced apart from each other in the first direction (D1), the plurality of semiconductor patterns comprising a first semiconductor pattern (200) comprising a first end and a second end along a dimension of the first semiconductor pattern (200) in a second direction (D2) that is different from the first direction (D1), wherein the first end is connected to the bit line (BL);
a word line structure (WL) extending in a third direction (D3) that is different from the first direction (D1) and from the second direction (D2), wherein the word line structure (WL) is on a first side of the first semiconductor pattern (200), the first side facing in the first direction (D1), wherein the first semiconductor pattern (200) comprises a first material;
a data storage pattern (DS) comprising:
a first electrode (310) connected to the second end of the first semiconductor pattern (200),
a second electrode (330) spaced apart from the first electrode (310), and
a dielectric layer (320) between the first and second electrodes (310, 330); and
an etch stop layer (130) between the word line structure (WL) and the first electrode (310) of the data storage pattern (DS), wherein the etch stop layer (130) is in contact with the first semiconductor pattern (200) and comprises a second material that is different from the first material,
wherein a length of the first electrode (310) of the data storage pattern (DS) in the first direction (D1) is greater than a length of the first semiconductor pattern (200) in the first direction (D1).

2. The semiconductor device of claim 1, wherein
the length (W1_310) of the first electrode (310) of the data storage pattern (DS) in the first direction (D1) is greater than 1.1 times and less than or equal to 5 times the length (W1_200) of the first semiconductor pattern (200) in the first direction (D1).

3. The semiconductor device of claim 1 or 2, wherein
the length (W1_310) of the first electrode (310) of the data storage pattern (DS) in the first direction (D1) is 0.5 times to 5.0 times a length (W2_310) of the first electrode (310) of the data storage pattern (DS) in the third direction (D3).

4. The semiconductor device of any one of the previous claims, wherein
a first side of the first electrode (310) of the data storage patterns (DS) in contact with a heterogeneous interface, wherein the first side faces the second direction (D2), and wherein the heterogeneous interface comprises at least a portion of the first semiconductor pattern (200) and at least a portion of the etch stop layer (130).

5. The semiconductor device of any one of the previous claims, wherein the first semiconductor pattern (200) extends through the etch stop layer (130) and is connected to the first electrode (310) of the data storage pattern (DS).

6. The semiconductor device of any one of the previous claims, wherein the semiconductor device comprises:
a first plurality of word line structures (WL1), including the word line structure (WL), on a first side of the plurality of the semiconductor patterns,
a second plurality of word line structures (WL2) on a second side of the plurality of semiconductor patterns, wherein the first side of the plurality of semiconductor patterns face in the first direction (D1) and the second side of the plurality of semiconductor patterns face in an opposite direction from the first direction (D1), and
a word line separation layer (150) between each word line structure (WL) of the first plurality of word line structures (WL1) and a corresponding word line structure of the second plurality of word line structures (WL2).

7. The semiconductor device of any one of the previous claims, wherein
the first electrode (310) of the data storage pattern (DS) comprises:
a first side wall (311) on a first side of the data storage pattern (DS), the first side facing in the second direction (D2);
a second side wall (312) facing in the first direction (D1) and a third side wall (313) facing in a direction opposite to that of the second side wall (312), the third side wall (313) spaced apart from the second side wall (312) in the first direction (D1), the second side wall (312) and the third side wall (313) in contact with the first side wall (311); and
a fourth side wall (314) facing in the third direction (D3) and a fifth side wall (315) facing in a direction opposite to that of the fourth side wall (314), the fifth side wall (315) spaced apart from the fourth side wall (314) in the third direction (D3), the fourth side wall (314) and the fifth side wall (315) in contact with the first side wall (311), the second side wall (312), and the third side wall (313).

8. The semiconductor device of any one of the previous claims, wherein
the first electrode (310) of the data storage pattern (DS) comprises: a first surface facing in the second direction (D2) and a sixth surface spaced apart from the first surface in the second direction (D2) and facing in a direction opposite to that of the first surface;
a second surface (BS_310) facing in the first direction (D1) and a third surface (US_310) spaced apart from the second surface (BS_310) in the first direction (D1) and facing in a direction opposite to that of the second surface (BS_310), the second surface (BS_310) and the third surface (US_310) in contact with the first surface and the sixth surface; and
a fourth surface facing in the third direction (D3) and a fifth surface spaced apart from the fourth surface in the third direction (D3) and facing in a direction opposite to that of the fourth surface, the fourth surface and the fifth surface in contact with the first surface, the second surface (BS_310), the third surface (US_310), and the sixth surface.

9. The semiconductor device of claim 1, wherein the semiconductor device comprises:
a semiconductor layer (250) between the word line and the first electrode (310) of the data storage pattern (DS), wherein the semiconductor layer (250) is in contact with the first semiconductor pattern (200), and wherein the semiconductor layer (250) comprises the first material.

10. The semiconductor device of claim 9, wherein
a length of the first electrode (310) of the data storage pattern (DS) in the first direction (D1) is greater than a length of the first semiconductor pattern (200) in the first direction (D1).

11. The semiconductor device of claim 9 or 10, wherein
the semiconductor layer (250) comprises:
an upper semiconductor layer portion above the first semiconductor pattern (200) in the first direction (D1); and
a lower semiconductor layer (250) portion below the first semiconductor pattern (200) in the first direction (D1).

12. The semiconductor device of any one of claims 9 to 11, comprising:
an etch stop layer (130) between the word line and the first electrode (310) of the data storage pattern (DS) in the second direction (D2), wherein the etch stop layer (130) is in contact with the first semiconductor pattern (200), wherein the etch stop layer (130) comprises a second material that is different from first material, and
wherein the semiconductor layer (250) is between the etch stop layer (130) and the first electrode (310) of the data storage pattern (DS) in the second direction (D2).

13. The semiconductor device of claim 1, wherein a length of the first electrode (310) of the data storage pattern (DS) in the first direction (D1) is greater than a length of the first semiconductor pattern (200) in the first direction (D1), and wherein the first electrode (310) comprises a first surface facing a first direction (D1) and a second surface (BS_310) facing in a direction opposite to that of the first direction (D1), wherein the first surface and the second surface (BS_310) of the first electrode (310) are non-overlapping with the word line structure (WL) in the second direction (D2).

14. The semiconductor device of claim 13, wherein
the first surface and the second surface (BS_310) of the first electrode (310) of the data storage pattern (DS) are non-overlapping with the first semiconductor pattern (200) in the second direction (D2).

15. The semiconductor device of claim 13 or 14, wherein
the semiconductor device comprises:
a first plurality of word line structures (WL1), including the word line structure (WL), on a first side of the plurality of the semiconductor patterns,
a second plurality of word line structures (WL2) on a second side of the plurality of semiconductor patterns, wherein the first side of the plurality of semiconductor patterns face in the first direction (D1) and the second side of the plurality of semiconductor patterns face in an opposite direction from the first direction (D1), and
a word line separation layer (150) between each word line structure (WL) of the first plurality of word line structures (WL1) and a corresponding word line structure of the second plurality of word line structures (WL2),
wherein the first surface and the second surface (BS_310) of the first electrode (310) of the data storage pattern (DS) are overlapping with the word line separation layer (150) in the second direction (D2).

## Amended claims

### Amended claims in accordance with Rule 137(2) EPC.

1. A semiconductor memory device comprising:
a bit line (BL) extending in a first direction (D1);
a plurality of semiconductor patterns spaced apart from each other in the first direction (D1), the plurality of semiconductor patterns comprising a first semiconductor pattern (200) comprising a first end and a second end along a dimension of the first semiconductor pattern (200) in a second direction (D2) that is different from the first direction (D1), wherein the first end is connected to the bit line (BL);
a word line structure (WL) extending in a third direction (D3) that is different from the first direction (D1) and from the second direction (D2), wherein the word line structure (WL) is on a first side of the first semiconductor pattern (200), the first side facing in the first direction (D1), wherein the first semiconductor pattern (200) comprises a first material;
a data storage pattern (DS) comprising:
a first electrode (310) connected to the second end of the first semiconductor pattern (200),
a second electrode (330) spaced apart from the first electrode (310), and
a dielectric layer (320) between the first and second electrodes (310, 330); and
an etch stop layer (130) between the word line structure (WL) and the first electrode (310) of the data storage pattern (DS), wherein the etch stop layer (130) is in contact with the first semiconductor pattern (200) and comprises a second material that is different from the first material;
wherein the semiconductor memory device comprising:
a first plurality of word line structures (WL1), including the word line structure (WL), on a first side of the plurality of the semiconductor patterns;
a second plurality of word line structures (WL2) on a second side of the plurality of semiconductor patterns, wherein the first side of the plurality of semiconductor patterns face in the first direction (D1) and the second side of the plurality of semiconductor patterns face in an opposite direction from the first direction (D1); and
a word line separation layer (150) between each word line structure (WL) of the first plurality of word line structures (WL1) and a corresponding word line structure of the second plurality of word line structures (WL2),wherein a length of the first electrode (310) of the data storage pattern (DS) in the first direction (D1) is greater than a length of the first semiconductor pattern (200) in the first direction (D1),
**characterized in that**:
the first electrode (310) comprises a first surface facing the first direction (D1) and a second surface (BS_310) facing in a direction opposite to that of the first direction (D1), and the first surface and the second surface (BS_310) of the first electrode (310) of the data storage pattern (DS) are overlapping with the word line separation layer (150) in the second direction (D2).

2. The semiconductor memory device of claim 1, wherein
the length (W1_310) of the first electrode (310) of the data storage pattern (DS) in the first direction (D1) is greater than 1.1 times and less than or equal to 5 times the length (W1_200) of the first semiconductor pattern (200) in the first direction (D1).

3. The semiconductor memory device of claim 1 or 2, wherein
the length (W1_310) of the first electrode (310) of the data storage pattern (DS) in the first direction (D1) is 0.5 times to 5.0 times a length (W2_310) of the first electrode (310) of the data storage pattern (DS) in the third direction (D3).

4. The semiconductor memory device of any one of the previous claims, wherein
a first side of the first electrode (310) of the data storage patterns (DS) is in contact with a heterogeneous interface, wherein the first side faces the second direction (D2), and wherein the heterogeneous interface comprises at least a portion of the first semiconductor pattern (200) and at least a portion of the etch stop layer (130).

5. The semiconductor memory device of any one of the previous claims, wherein
the first semiconductor pattern (200) extends through the etch stop layer (130) and is connected to the first electrode (310) of the data storage pattern (DS).

6. The semiconductor memory device of any one of the previous claims, wherein
the first electrode (310) of the data storage pattern (DS) comprises:
a first side wall (311) on a first side of the data storage pattern (DS), the first side facing in the second direction (D2);
a second side wall (312) facing in the first direction (D1) and a third side wall (313) facing in a direction opposite to that of the second side wall (312), the third side wall (313) spaced apart from the second side wall (312) in the first direction (D1), the second side wall (312) and the third side wall (313) in contact with the first side wall (311); and
a fourth side wall (314) facing in the third direction (D3) and a fifth side wall (315) facing in a direction opposite to that of the fourth side wall (314), the fifth side wall (315) spaced apart from the fourth side wall (314) in the third direction (D3), the fourth side wall (314) and the fifth side wall (315) in contact with the first side wall (311), the second side wall (312), and the third side wall (313).

7. The semiconductor memory device of any one of the previous claims, wherein
the first electrode (310) of the data storage pattern (DS) comprises: a first surface facing in the second direction (D2) and a sixth surface spaced apart from the first surface in the second direction (D2) and facing in a direction opposite to that of the first surface;
a second surface (BS_310) facing in the first direction (D1) and a third surface (US_310) spaced apart from the second surface (BS_310) in the first direction (D1) and facing in a direction opposite to that of the second surface (BS_310), the second surface (BS_310) and the third surface (US_310) in contact with the first surface and the sixth surface; and
a fourth surface facing in the third direction (D3) and a fifth surface spaced apart from the fourth surface in the third direction (D3) and facing in a direction opposite to that of the fourth surface, the fourth surface and the fifth surface in contact with the first surface, the second surface (BS_310), the third surface (US_310), and the sixth surface.

8. The semiconductor memory device of claim 1, wherein the semiconductor device comprises:
a semiconductor layer (250) between the word line and the first electrode (310) of the data storage pattern (DS), wherein the semiconductor layer (250) is in contact with the first semiconductor pattern (200), and wherein the semiconductor layer (250) comprises the first material.

9. The semiconductor memory device of claim 8, wherein
the semiconductor layer (250) comprises:
an upper semiconductor layer portion above the first semiconductor pattern (200) in the first direction (D1); and
a lower semiconductor layer (250) portion below the first semiconductor pattern (200) in the first direction (D1).

10. The semiconductor memory device of any one of claims 8 to 9,
wherein the semiconductor layer (250) is between the etch stop layer (130) and the first electrode (310) of the data storage pattern (DS) in the second direction (D2).

11. The semiconductor memory device of claim 1, wherein
the first surface and the second surface (BS_310) of the first electrode (310) of the data storage pattern (DS) are non-overlapping with the first semiconductor pattern (200) in the second direction (D2).
